(19) Europäisches Patentamt
European Patent Office
Office européen des brevets

(11) EP 3 805 338 B1

(12) **EUROPÄISCHE PATENTSCHRIFT**

(45) Veröffentlichungstag und Bekanntmachung des Hinweises auf die Patenterteilung:
**19.06.2024 Patentblatt 2024/25**

(21) Anmeldenummer: **20191338.1**

(22) Anmeldetag: **18.08.2004**

(51) Internationale Patentklassifikation (IPC):
***C09K 11/06*** *(2006.01)* ***B01J 31/22*** *(2006.01)*
***C07F 15/00*** *(2006.01)*

(52) Gemeinsame Patentklassifikation (CPC):
**B01J 31/2273; C07F 15/0033; C09B 57/00; C09B 57/10; C09K 11/06; H10K 85/342;**
B01J 31/2265; B01J 2531/16; B01J 2531/17; B01J 2531/18; B01J 2531/57; B01J 2531/60; B01J 2531/70; B01J 2531/821; B01J 2531/822;

(Forts.)

(54) **ÜBERGANGSMETALLKOMPLEXE MIT CARBENLIGANDEN ALS EMITTER FÜR ORGANISCHE LICHTEMITTIERENDE DIODEN (OLEDS)**

TRANSITION METAL COMPLEXES COMPRISING CARBENE LIGANDS AS EMITTERS FOR ORGANIC LIGHT-EMITTING DIODES (OLEDS)

COMPLEXES DE MÉTAUX DE TRANSITION COMPRENANT DES LIGANDS CARBÈNES EN TANT QU'ÉMETTEUR POUR DIODES ÉLECTROLUMINESCENTES ORGANIQUES (OLED)

(84) Benannte Vertragsstaaten:
**AT BE BG CH CY CZ DE DK EE ES FI FR GB GR HU IE IT LI LU MC NL PL PT RO SE SI SK TR**

(30) Priorität: **19.08.2003 DE 10338550**

(43) Veröffentlichungstag der Anmeldung:
**14.04.2021 Patentblatt 2021/15**

(62) Dokumentnummer(n) der früheren Anmeldung(en) nach Art. 76 EPÜ:
**17191410.4 / 3 299 437**
**04764255.8 / 1 658 349**

(73) Patentinhaber: **UDC Ireland Limited**
**Ballycoolin, Dublin 15 (IE)**

(72) Erfinder:
- **BOLD, Markus**
  **67246 Dirmstein (DE)**
- **LENNARTZ, Christian**
  **67105 Schifferstadt (DE)**
- **PRINZ, Martina**
  **69221 Dossenheim (DE)**
- **SCHMIDT, Hans-Werner**
  **95444 Bayreuth (DE)**
- **THELAKKAT, Mukundan**
  **95445 Bayreuth (DE)**
- **BÄTE, Markus**
  **95508 Kulmain (DE)**
- **NEUBER, Christian**
  **95445 Bayreuth (DE)**
- **KOWALSKY, Wolfgang**
  **38116 Braunschweig (DE)**
- **SCHILDKNECHT, Christian**
  **38112 Braunschweig (DE)**
- **JOHANNES, Hans-Hermann**
  **38124 Braunschweig (DE)**

(74) Vertreter: **Maiwald GmbH**
**Elisenhof**
**Elisenstraße 3**
**80335 München (DE)**

(56) Entgegenhaltungen:
**DE-A1- 10 062 577**

- **P. HITCHCOCK ET.AL.: "Synthesis of homoleptic tris(organo-chelate)iridium(III) complexes by spontaneous ortho-metallation of electronrich olefin-derived N,N?-diarylcarbene ligands and the X-ray structures of fac-[6H3Me-p}3] and mer-6H3Me-p}2 {C6H4Me-p}Cl (a product of HCl cleavage)", JOURNALOF ORGANOMETALLIC CHEMISTRY, Bd. 239, 1982, Seiten C26-C30, XP002309658,**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- **A. CHIANESE ET.AL.: "Rhodium and iridium complexes of N-heterocyclic carbenes via transmetalation: structure and dynamics", ORGANOMETALLICS, Bd. 22, 13. März 2003 (2003-03-13), Seiten 1663-1667, XP002309659,**
- **POLLY L. ARNOLD: "Organometallic chemistry of silver and copperN-heterocyclic carbene complexes", HETEROATOM CHEMISTRY, Bd. 13, Nr. 6, 1. Januar 2002 (2002-01-01) , Seiten 534-539, XP055433503, US ISSN: 1042-7163, DOI: 10.1002/hc.10098**

(52) Gemeinsame Patentklassifikation (CPC): (Forts.)
B01J 2531/827; B01J 2531/828; C09K 2211/1007; C09K 2211/1018; C09K 2211/1044; C09K 2211/1059; C09K 2211/18; C09K 2211/185; H10K 50/11; H10K 50/18; H10K 50/181; H10K 85/324; H10K 2101/10; Y02P 20/582

**Beschreibung**

Die vorliegende Erfindung betrifft die Verwendung von Übergangsmetallkomplexen enthaltend mindestens einen Carbenliganden in organischen Licht-emittierenden Dioden (OLEDs), OLEDS enthaltend diese Übergangsmetallkomplexe, und Vorrichtungen, die ein erfindungsgemäßes OLED enthalten.

In organischen Licht-emittierenden Dioden (OLED) wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigeren Stromverbrauchs eignen sich Vorrichtungen enthaltend OLEDs insbesondere für mobile Anwendungen, zum Beispiel für Anwendungen in Handys, Laptops usw.

Es wurden zahlreiche Materialien vorgeschlagen, die bei der Anregung durch elektrischen Strom Licht emittieren.

WO 02/15645 betrifft OLEDs, die eine Licht-emittierende Schicht aufweisen, die phosphoreszierende Übergangsmetallverbindungen enthält. Die Übergangsmetallverbindungen zeigen Elektrophosphoreszenz, insbesondere im blauen Bereich des sichtbaren elektromagnetischen Spektrums. Die Farbkoordinaten des von den in WO 02/15645 offenbarten Komplexen emittierten Blau sind jedoch verbesserungswürdig.

WO 01/41512 betrifft OLEDs, die eine Licht-emittierende Schicht aufweisen, die ein Molekül der allgemeinen Formel $L_2MX$ enthält, wobei M besonders bevorzugt Iridium ist und L ausgewählt ist aus der Gruppe bestehend aus 2-(1-Naphthyl)benzooxazol, 2-Phenylbenzooxazol, 2-Phenylbenzothiazol, 7,8-Benzochinolin, Cumaren, Thienylpyridin, Phenylpyridin, Benzothienylpyridin, 3-Methoxy-2-phenylpyridin und Tolylpyridin und X ausgewählt ist aus der Gruppe bestehend aus Acetylacetonat, Hexafluoracetylacetonat, Salicyliden, Picolinat und 8-Hydroxychinolinat.

WO 00/70655 betrifft elektrolumineszierende Schichten, die als Licht-emittierende Substanz eine phosphoreszierende organometallische Iridiumverbindung oder Osmiumverbindung aufweisen. Bevorzugt wird Tris(2-phenylpyridin)iridium als Licht-emittierende Verbindung eingesetzt.

Obwohl bereits Verbindungen bekannt sind, die im blauen, roten und grünen Bereich des elektromagnetischen Spektrums Elektrolumineszenz zeigen, ist die Bereitstellung von effizienteren Verbindungen, die technisch einsetzbar sind, wünschenswert. Unter Elektrolumineszenz ist sowohl Elektrofluoreszenz als auch Elektrophosphoreszenz zu verstehen. Des Weiteren ist die Bereitstellung von weiteren Verbindungen zum Einsatz als Elektronen, Excitonen oder Löcher blockierende Materialien von Interesse.

Aufgabe der vorliegenden Anmeldung ist daher die Bereitstellung einer Verbindungsklasse, die zur Elektrolumineszenz im blauen, roten und grünen Bereich des elektromagnetischen Spektrums geeignet ist, wodurch die Herstellung von Vollfarbendisplays ermöglicht wird. Eine weitere Aufgabe der vorliegenden Anmeldung ist die Bereitstellung von Verbindungen zum Einsatz als Elektronen, Excitonen oder Löcher blockierende Materialien.

Diese Aufgaben werden durch die Verwendung von neutralen Übergangsmetallkomplexen der allgemeinen Formel I, enthaltend mindestens einen Carbenliganden in organischen Licht-emittierenden Dioden (OLEDs) gelöst

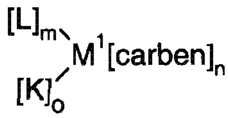 (I)

worin die Symbole die folgenden Bedeutungen aufweisen:

- $M^1$ Metallatom ausgewählt aus der Gruppe bestehend aus Ir und Pt in jeder für das entsprechende Metallatom möglichen Oxidationsstufe;
- carben Carbenligand, umfassend die weiter unten definierte Formel (II);
- L mono- oder dianionischer Ligand, bevorzugt monoanionischer Ligand, der mono- oder bidentat sein kann;
- K neutraler mono- oder bidentater Ligand ausgewählt aus der Gruppe bestehend aus Phosphinen, bevorzugt Trialkyl-, Triaryl- oder Alkylarylphosphinen, besonders bevorzugt $PAr_3$, wobei Ar ein substituierter oder unsubstituierter Arylrest ist und die drei Arylreste in $PAr_3$ gleich oder verscheiden sein können, besonders bevorzugt $PPh_3$, $PEt_3$, $PnBu_3$, $PEt_2Ph$, $PMe_2Ph$, $PnBu_2Ph$; Phosphonaten und Derivaten davon, Arsenaten und Derivaten davon, Phosphiten; CO; Pyridinen, wobei die Pyridine mit Alkyl- oder Arylgruppen substituiert sein können; Nitrilen und Dienen, die einen $\pi$-Komplex mit $M^1$ bilden, bevorzugt $\eta^4$-Diphenyl-1,3-butadien, $\eta^4$-1,3-Pentadien, $\eta^4$-1-Phenyl-1,3-pentadien, $\eta^4$-1,4-Dibenzyl-1,3-butadien, $\eta^4$-2,4-Hexadien, $\eta^4$-3-Methyl-1,3-pentadien, $\eta^4$-1,4-Ditolyl-1,3-butadien, $\eta^4$-1,4-Bis(trimethylsilyl)-1,3-butadien und $\eta^2$- oder $\eta^4$-Cyclooctadien (je 1,3 und je 1,5), besonders bevorzugt 1,4-Diphenyl-1,3-butadien, 1-Phenyl-1,3-pentadien, 2,4-Hexadien, Butadien, $\eta^2$-Cycloocten, $\eta^4$-1,3-Cyclooctadien und $\eta^4$-1,5-Cyclooctadien;

n Zahl der Carbenliganden, wobei n mindestens 1 ist und die Carbenliganden in dem Komplex der Formel I bei n >1 gleich oder verschieden sein können;

m Zahl der Liganden L, wobei m 0 oder ≥ 1 sein kann und die Liganden L bei m > 1 gleich oder verschieden sein können;

o Zahl der Liganden K, wobei o 0 oder ≥ 1 sein kann und die Liganden K bei o > 1 gleich oder verschieden sein können;

wobei die Summe n + m + o von der Oxidationsstufe und Koordinationszahl des eingesetzten Metallatoms und von der Zähnigkeit der Liganden carben, L und K sowie von der Ladung der Liganden carben und L abhängig ist, mit der Bedingung, dass n mindestens 1 ist.

Die Übergangsmetallkomplexe der Formel I können in jeder Schicht eines OLEDs eingesetzt werden, wobei das Ligandgerüst oder Zentralmetall zur Anpassung an gewünschte Eigenschaften der Metallkomplexe variiert werden kann. Beispielsweise ist der Einsatz der Übergangsmetallkomplexe der Formel I in einer Blockschicht für Elektronen, einer Blockschicht für Excitonen, einer Blockschicht für Löcher oder der Licht-emittierenden Schicht des OLEDs möglich. Bevorzugt werden die Verbindungen der Formel I als Emittermoleküle in OLEDs eingesetzt.

Unter einem bidentaten Liganden ist ein Ligand zu verstehen, der an zwei Stellen an das Übergangsmetallatom $M^1$ koordiniert ist. Im Sinne der vorliegenden Anmeldung wird der Begriff "zweizähnig" synonym mit dem Begriff "bidentat" verwendet.

Unter einem monodentaten Liganden ist ein Ligand zu verstehen, der an einer Stelle des Liganden mit dem Übergangsmetallatom $M^1$ koordiniert.

In Abhängigkeit von der Koordinationszahl des eingesetzten Metalls $M^1$ und der Natur und Zahl der eingesetzten Liganden L, K und carben können verschiedene Isomere der entsprechenden Metallkomplexe bei gleichem Metall $M^1$ und gleicher Natur und Zahl der eingesetzten Liganden K, L und carben vorliegen. Zum Beispiel sind bei Komplexen mit einem Metall $M^1$ mit der Koordinationszahl 6 (also oktaedrischen Komplexen), zum Beispiel Ir(III)-Komplexen, sowohl cis/trans-Isomere möglich, wenn es sich um Komplexe der allgemeinen Zusammensetzung $MA_2B_4$ handelt, als auch fac-mer-Isomere (facial/meridional-Isomere), wenn es sich um Komplexe der allgemeinen Zusammensetzung $MA_3B_3$ handelt. Bei quadratisch planaren Komplexen mit einem Metall $M^1$ mit der Koordinationszahl 4, zum Beispiel Pt(II)-Komplexen, sind cis/trans-Isomere möglich, wenn es sich um Komplexe der allgemeinen Zusammmensetzung $MA_2B_2$ handelt. Bei den Symbolen A und B handelt es sich jeweils um eine Bindungsstelle eines Liganden, wobei nicht nur monodentate, sondern auch bidentate Liganden vorliegen können. Ein unsymmetrischer bidentater Ligand weist gemäß der vorstehend erwähnten allgemeinen Zusammensetzung eine Gruppe A und eine Gruppe B auf.

Dem Fachmann ist bekannt, was unter cis/trans- bzw. fac-mer-Isomeren zu verstehen ist. Bei oktaedrischen Komplexen bedeutet cis-Isomerie, dass bei Komplexen der Zusammensetzung $MA_2B_4$ die beiden Gruppen A benachbarte Ecken eines Oktaeders belegen, während die beiden Gruppen A bei der trans-Isomerie einander gegenüber liegende Ecken eines Oktaeders belegen. Bei Komplexen der Zusammensetzung $MA_3B_3$ können drei Gruppen der gleichen Art entweder die Ecken einer Oktaederfläche besetzen (faciales Isomer) oder einen Meridian, das heißt zwei der drei Ligandenbindungsstellen sind zueinander trans-ständig (meridionales Isomer). Bezüglich der Definition von cis/trans-Isomeren bzw. fac-mer-Isomeren in oktaedrischen Metallkomplexen siehe zum Beispiel J. Huheey, E. Keiter, R. Keiter, Anorganische Chemie: Prinzipien von Struktur und Reaktivität, 2., neu bearbeitete Auflage, übersetzt und erweitert von Ralf Steudel, Berlin; New York: de Gruyter, 1995, Seiten 575, 576.

Bei quadratisch planaren Komplexen bedeutet cis-Isomerie, dass bei Komplexen der Zusammensetzung $MA_2B_2$ sowohl die beiden Gruppen A als als auch die beiden Gruppen B benachbarte Ecken eines Quadrats belegen, während sowohl die beiden Gruppen A als auch die beiden Gruppen B bei der trans-Isomerie jeweils die beiden einander diagonal gegenüber liegenden Ecken eines Quadrats belegen. Bezüglich der Definition von cis/trans-Isomeren in quadratisch planaren Metallkomplexen siehe zum Beispiel J. Huheey, E. Keiter, R, Keiter, Anorganische Chemie: Prinzipien von Struktur und Reaktivität, 2., neu bearbeitete Auflage, übersetzt und erweitert von Ralf Stendel, Berlin; New York: de Gruyter, 1995, Seiten 557 bis 559.

Im Allgemeinen können die verschiedenen Isomere der Metallkomplexe der Formel I nach dem Fachmann bekannten Verfahren, zum Beispiel durch Chromatographie, Sublimation oder Kristallisation, getrennt werden.

Die vorliegende Erfindung verwendet somit sowohl jeweils einzelne Isomere der Übergangsmetallkomplexe der Formel I als auch Gemische verschiedener Isomere in jedem beliebigen Mischungsverhältnis.

Übergangsmetallkomplexe, die Carbenliganden enthalten, sind im Stand der Technik bekannt. So betreffen Gründemann et al., J. Am. Chem. Soc., 2002, 124, 10473 bis 10481 und Danapoulos et al., J. Chem. Soc., Dalton Trans., 2002 3090 bis 3091 Iridiumkomplexe, die einen Carbenliganden mit der folgenden Struktureinheit

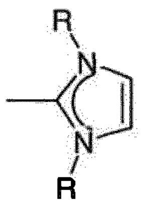

aufweisen. In Hitchcock et al. J. Organomet. Chem., 1982, 239, C 26-C 30 sind Iridium(III)-Komplexe offenbart, die drei monoanionische Carbenliganden aufweisen, und die die folgende Strukturformel besitzen

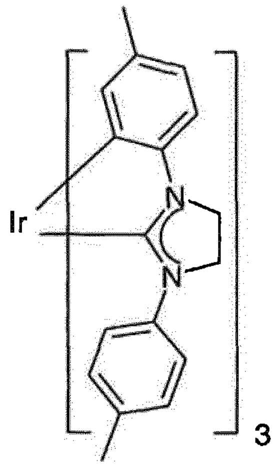

In keinem der genannten Dokumente sind jedoch Lumineszenzeigenschaften, insbesondere Elektrolumineszenzeigenschaften, der offenbarten Verbindungen bzw. deren Verwendungen in OLEDs offenbart.

In Yam et al., Chem. Commun. 1989, 2261 bis 2262 und Yam et al., J. Chem. Soc. Dalton Trans., 2001, 1911 bis 1919 sind Ruthenium-Komplexe offenbart, die einen Carbenliganden aufweisen. Die photophysikalischen Eigenschaften dieser Carbenkomplexe, unter anderem die Photolumineszenz der Komplexe wurde in den genannten Dokumenten untersucht. Es werden jedoch keine Angaben bezüglich einer Verwendung dieser Komplexe gemacht, noch enthalten die Dokumente Angaben bezüglich der Elektrolumineszenz der untersuchten Verbindungen.

Che et al., Organometallics 1998, 17, 1622 bis 1630 betrifft kationische Re-Komplexe, die einen Carbenliganden mit der folgenden Struktureinheit

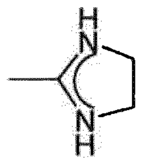

aufweisen.

Dieser Komplex zeigt Photolumineszenz. Eine Verwendung des Re-Komplexes sowie die Untersuchung des Elektrolumineszenzverhaltens des Komplexes ist jedoch nicht offenbart.

US 6,160,267 und US 6,338,977 betreffen eine molekulare Licht-emittierende Diode, die ihre Farbe in Abhängigkeit von sie umgebenden Dämpfen ändert. Diese Elektrode weist eine Sensor-Emitterschicht auf, die einen neutralen Platinkomplex enthält, wobei Platin durch zwei negativ geladene Liganden, ausgewählt aus der Gruppe bestehend aus $CN^-$, $NO_2^-$, $NCO^-$, $NCS^-$, $Cl^-$, $Br^-$, $I^-$ und Oxalat, koordiniert ist und die weiteren zwei Liganden ausgewählt sind aus mindestens einer und maximal zwei Arylisonitrilgruppen und einem Fischer-Carben-Komplex, der die Formel =C(Y)-NH-$C_6H_4$-Alkyl aufweist, worin Y O-Alkyl, NH-Alkyl oder $N(Alkyl)_2$ ist. Zwingendes Merkmal der in US 6,160,267 und US 6,338,977 offenbarten Pt-Komplexe ist die Anwesenheit mindestens einer Arylisonitrilgruppe.

Die Eignung von Übergangsmetallkomplexen der Formel I die mindestens einen Carbenliganden tragen, als Licht-emittierende Substanzen in OLEDs, wobei die Substanzen dieses Strukturtyps gemäß Formel I zur Elektrolumineszenz im roten, grünen und blauen Bereich des elektromagnetischen Spektrums geeignet sind, ist in keinem der vorstehend genannten Dokumente erwähnt.

Es wurde somit gefunden, dass die Übergangsmetallkomplexe der Formel I als Licht-emittierende Substanzen in OLEDs zur Herstellung von Volltarbendisplays geeignet sind.

Als Metallatom $M^1$ werden Ir oder Pt eingesetzt, bevorzugt Ir(III) oder Pt(II), ganz besonders bevorzugt Ir(III).

Geeignete mono- oder dianionische Liganden L, bevorzugt monoanionische Liganden L, die mono- oder bidentat sein können, sind die üblicherweise als mono- oder bidentate mono- oder dianionische Liganden eingesetzten Liganden.

Geeignete monoanionische monodentate Liganden sind zum Beispiel Halogenide, insbesondere $Cl^-$ und $Br^-$, Pseudohalogenide, insbesondere $CN^-$, Cyclopentadienyl ($Cp^-$), Alkylreste, die mit dem Übergangsmetall $M^1$ über eine Sigmabindung verknüpft sind, zum Beispiel $CH_3$, Alkylarylreste, die mit dem Übergangsmetall $M^1$ über eine Sigmabindung verknüpft sind, zum Beispiel Benzyl.

Geeignete monoanionische bidentate Liganden sind zum Beispiel Acetylacetonat und dessen Derivate, Picolinat, Schiffsche Basen, Aminosäuren sowie die in WO 02/15645 genannten bidentaten monoanionischen Liganden, wobei Acetylacetonat und Picolinat bevorzugt sind.

Geeignete neutrale mono- oder bidentate Liganden sind bereits vorstehend genannt. Bevorzugte neutrale monodentate Liganden sind ausgewählt aus der Gruppe bestehend aus $PPh_3$, $P(OPh)_3$, $AsPh_3$, CO, Pyridin, Nitrilen und deren Derivaten. Geeignete neutrale mono- bzw. bidentate Liganden sind bevorzugt 1,4-Diphenyl-1,3-butadien, 1-Phenyl-1,3-pentadien, 2,4-Hexadien, $\eta^4$-Cyclooctadien und $\eta^2$-Cyclooctadien (je 1,3 und je 1,5).

Die Zahl n der Carbenliganden beträgt in neutralen Übergangsmetallkomplexen, worin das Übergangsmetallatom Ir(III) eine Koordinationszahl von 6 aufweist, 1 bis 3, bevorzugt 2 oder 3, besonders bevorzugt 3. Ist n > 1 können die Carbenliganden gleich oder verschieden sein, bevorzugt sind sie gleich.

Die Zahl n der Carbenliganden beträgt in Übergangsmetallkomplexen, worin das Übergangsmetallatom Pt(II) eine Koordinationszahl von 4 aufweist, 1 oder 2, bevorzugt 2. Ist n > 1 können die Carbenliganden gleich oder verschieden sein.

Die Zahl m der monoanionischen Liganden L beträgt in dem vorstehend genannten Fall 0 bis 2, bevorzugt 0 bis 1, besonders bevorzugt 0. Ist m > 1 können die Liganden L gleich oder verschieden sein, bevorzugt sind sie gleich.

Die Zahl oder neutralen Liganden K ist abhängig davon, ob die Koordinationszahl 6 des Ir(III) oder 4 des Pt(II) mit Hilfe der Carbenliganden und der Liganden L bereits erreicht wurde. Ist - in dem Fall, dass Ir(III) eingesetzt wird - n drei und werden drei monoanionische bidentate Carbenliganden eingesetzt, so ist o in dem vorstehend genannten Fall 0. Ist - in dem Fall, dass Pt(II) eingesetzt wird - n zwei und werden zwei monoanionische bidentate Carbenliganden eingesetzt, so ist o in diesem Fall ebenfalls 0.

In einer Ausführungsform betrifft die vorliegende Erfindung eine OLED mit einem Übergangsmetallkomplex der Formel IA

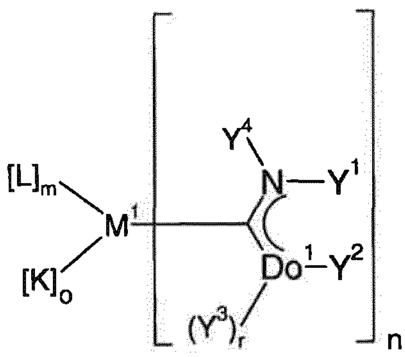

(IA)

worin die Symbole die folgenden Bedeutungen aufweisen:

$Do^1$ Donoratom ausgewählt aus der Gruppe bestehend aus C, N, O, P und S, bevorzugt N, O, P und S, besonders bevorzugt N;

r 2, wenn $Do^1$ C ist,1, wenn $Do^1$ N oder P ist und 0, wenn $Do^1$ O oder S ist;

$Y^1$, $Y^2$ jeweils unabhängig voneinander Wasserstoff oder eine kohlenstoffhaltige Gruppe ausgewählt aus der Gruppe bestehend aus Alkyl-, Aryl-, Heteroaryl- und Alkenylgruppen, bevorzugt Alkyl- und Arylgruppen, oder
$Y^1$ und $Y^2$ bilden gemeinsam eine Brücke zwischen dem Donoratom $Do^1$ und dem Stickstoffatom N, die mindestens zwei Atome, bevorzugt zwei bis drei Atome, besonders bevorzugt zwei Atome, aufweist, wovon mindestens eines ein Kohlenstoffatom ist, und die weiteren Atome bevorzugt Stickstoff- oder Kohlenstoffatome

sind, wobei die Brücke gesättigt oder ungesättigt, bevorzugt ungesättigt, sein kann und die mindestens zwei Atome der Brücke substituiert oder unsubstituiert sein können;

$Y^3$, $Y^4$ jeweils unabhängig voneinander ein Wasserstoff-, Alkyl-, Aryl-, Heteroaryl- oder Alkenylrest; bevorzugt Wasserstoff, ein Alkyl-, Heteroaryl- oder ein Arylrest,

wobei $Y^1$, $Y^2$, $Y^3$ und $Y^4$ nicht gleichzeitig Wasserstoff sein können.

Die Symbole $M^1$, L, K sowie n, m und o wurden bereits vorstehend erwähnt.

Für die Gruppen $Y^1$ und $Y^2$ gilt im Sinne der vorliegenden Anmeldung:
die Substituenten der Gruppen $Y^1$ und $Y^2$ können gemeinsam eine Brücke bilden mit insgesamt drei bis fünf, bevorzugt vier Atomen, wovon ein oder zwei Atome Heteroatome, bevorzugt N, sein können und die restlichen Atome Kohlenstoffatome sind, so dass $Y^1$ und $Y^2$ gemeinsam mit dieser Brücke einen fünf- bis siebengliedrigen, bevorzugt sechsgliedrigen Ring bilden, der gegebenenfalls zwei - oder im Falle eines sechs- oder siebengliedrigen Rings - drei Doppelbindungen aufweisen kann und gegebenenfalls mit Alkyl- oder Arylgruppen substituiert sein kann und gegebenenfalls Heteroatome, bevorzugt N, enthalten kann, wobei ein sechsgliedriger aromatischer Ring, der mit Alkyl- oder Arylgruppen substituiert oder unsubstituiert ist, bevorzugt ist, oder der bevorzugte sechsgliedrige aromatische Ring ist mit weiteren Ringen, die gegebenenfalls mindestens ein Heteroatom, bevorzugt N, enthalten können, bevorzugt sechsgliedrigen aromatischen Ringen anelliert.

Im Sinne der vorliegenden Anmeldung haben die Begriffe Arylrest oder -gruppe, Heteroarylrest oder -gruppe, Alkylrest oder -gruppe und Alkenylrest oder -gruppe die folgenden Bedeutungen:
Unter einem Arylrest (oder -gruppe) ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind zum Beispiel Alkylreste, bevorzugt Alkylreste mit 1 bis 8 Kohlenstoffatomen, besonders bevorzugt Methyl, Ethyl oder i-Propyl, Arylreste, bevorzugt $C_6$-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder Gruppen mit Donor- oder Akzeptorwirkung. Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I- und/oder -M-Effekt aufweisen. Geeignete Gruppen mit Donor- oder Akzeptorwirkung sind Halogenreste, bevorzugt F, Cl, Br, besonders bevorzugt F, Alkoxyreste, Aryloxyreste, Carbonylreste, Esterreste, Aminreste, Amidreste, $CH_2F$-Gruppen, $CHF_2$-Gruppen, $CF_3$-Gruppen, CN-Gruppen, Thiogruppen oder SCN-Gruppen. Ganz besonders bevorzugt tragen die Arylreste Substituenten ausgewählt aus der Gruppe bestehend aus Methyl, F, Cl, Aryloxy und Alkoxy. Bevorzugt ist der Arylrest oder die Arylgruppe ein $C_6$-$C_{18}$-Arylrest, besonders bevorzugt ein $C_6$-Arylrest, der gegebenenfalls mit mindestens einem der vorstehend genannten Substituenten substituiert ist. Besonders bevorzugt weist der $C_6$-$C_{18}$-Arylrest, bevorzugt $C_6$-Arylrest, einen oder zwei der vorstehend genannten Substituenten auf, wobei im Falle eines $C_6$-Arylrests der eine Substituent in ortho-, meta- oder para-Position zur weiteren Verknüpfungsstelle des Arylrestes angeordnet ist, und - im Falle von zwei Substituenten - können diese jeweils in meta-Position oder ortho-Position zur weiteren Verknüpfungsstelle des Arylrestes angeordnet sein, oder ein Rest ist in ortho-Position und ein Rest in meta-Position angeordnet, oder ein Rest ist in ortho- oder meta-Position angeordnet und der weitere Rest ist in para-Position angeordnet.

Unter einem Heteroarylrest oder einer Heteroarylgruppe sind Reste zu verstehen, die sich von den vorstehend genannten Arylresten dadurch unterscheiden, dass in dem Grundgerüst der Arylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Arylreste durch Heteroatome ersetzt. Insbesondere bevorzugt ist das Grundgerüst ausgewählt aus elektronenreichen Systemen wie Pyridyl und fünfgliedrigen Heteroaromaten wie Pyrrol, Furane. Das Grundgerüst kann an einer, mehreren oder allen substituierbaren Positionen des Grundgerüsts substituiert sein. Geeignete Substituenten sind dieselben, die bereits bezüglich der Arylgruppen genannt wurden.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8 Kohlenstoffatomen zu verstehen. Dieser Alkylrest kann verzweigt oder unverzweigt sein und gegebenenfalls mit einem oder mehreren Heteroatomen, bevorzugt Si, N, O oder S, besonders bevorzugt N, O oder S, unterbrochen sein. Des Weiteren kann dieser Alkylrest mit einem oder mehreren der bezüglich der Arylgruppen genannten Substituenten substituiert sein. Es ist ebenfalls möglich, dass der Alkylrest eine oder mehrere Arylgruppen trägt. Dabei sind alle der vorstehend aufgeführten Arylgruppen geeignet. Besonders bevorzugt sind die Alkylreste ausgewählt aus der Gruppe bestehend aus Methyl und iso-Propyl.

Unter einem Alkenylrest oder einer Alkenylgruppe ist ein Rest zu verstehen, der den vorstehend genannten

Alkylresten mit mindestens zwei Kohlenstoffatomen entspricht, mit dem Unterschied, dass mindestens eine C-C-Einfachbindung des Alkylrests durch eine C-C-Doppelbindung ersetzt ist. Bevorzugt weist der Alkenylrest eine oder zwei Doppelbindungen auf.

Unter einer Brücke, die mindestens zwei Atome aufweist, wovon mindestens eines ein Kohlenstoffatom ist und die weiteren Atome bevorzugt Stickstoff- oder Kohlenstoffatome sind, wobei die Brücke gesättigt oder bevorzugt ungesättigt sein kann und die mindestens zwei Atome der Brücke substituiert oder unsubstituiert sein können, sind bevorzugt die folgenden Gruppen zu verstehen:

- Eine Brücke, die zwei Kohlenstoffatome oder ein Kohlenstoffatom und ein Stickstoffatom aufweist, wobei die Kohlenstoffatome bzw. ein Kohlenstoffatom und ein Stickstoffatom durch eine Doppelbindung miteinander verbunden sind, so dass die Brücke eine der folgenden Formeln aufweist, wobei die Brücke bevorzugt zwei Kohlenstoffatome aufweist:

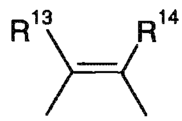

oder

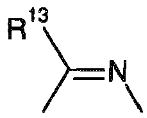

$R^{13}$ und $R^{14}$ bedeuten unabhängig voneinander Wasserstoff, Alkyl oder Aryl
oder
$R^{13}$ und $R^{14}$ bilden gemeinsam eine Brücke mit insgesamt 3 bis 5, bevorzugt 4, Atomen, wovon gegebenenfalls ein oder zwei Atome Heteroatome, bevorzugt N, sein können und die restlichen Atome Kohlenstoffatome sind, so dass diese Gruppe einen 5- bis 7-gliedrigen, bevorzugt sechsgliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen substituiert sein kann. Bevorzugt ist dabei ein sechsgliedriger aromatischer Ring. Dieser kann mit Alkyl- oder Arylgruppen substituiert oder unsubstituiert sein. Des Weiteren ist es möglich, dass an diesem, bevorzugt sechsgliedrigen, aromatischen Ring ein oder mehrere weitere aromatische Ringe anelliert sind. Dabei ist jede denkbare Anellierung möglich. Diese anellierten Reste können wiederum substituiert sein, bevorzugt mit den in der allgemeinen Definition der Arylreste genannten Resten.

- Eine Brücke, die zwei Kohlenstoffatome aufweist, wobei die Kohlenstoffatome durch eine Einfachbindung miteinander verbunden sind, so dass die Brücke die folgende Formel aufweist:

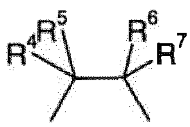

worin $R^4$,

$R^5$, $R^6$ und $R^7$ unabhängig voneinander Wasserstoff, Alkyl, Aryl, Heteroaryl oder Alkenyl bedeuten, bevorzugt Wasserstoff, Alkyl oder Aryl.

Ganz besonders bevorzugt ist $M^1$ in dem Übergangsmetallkomplex der Formel IA Ir(III).

Die Gruppierung

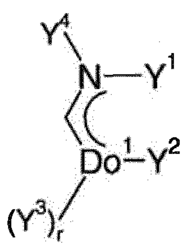

ist ganz besonders bevorzugt ausgewählt aus der Gruppe bestehend aus

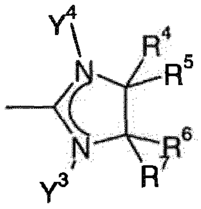 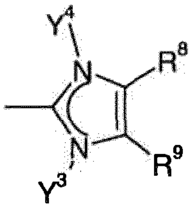 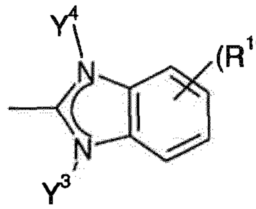 und 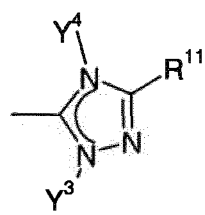

a b c d

worin die Symbole die folgenden Bedeutungen aufweisen

| | |
|---|---|
| $R^4$, $R^5$, $R^6$, $R^7$, $R^8$, $R^9$ und $R^{11}$ | Wasserstoff, Alkyl, Aryl, Heteroaryl, Alkenyl, oder ein Substituent mit Donor- oder Akzeptorwirkung bevorzugt ausgewählt aus Halogenresten, bevorzugt F, Cl, Br, besonders bevorzugt F, Alkoxyresten, Aryloxyresten, Carbonylresten, Esterresten, Aminresten, Amidresten, $CH_2F$-Gruppen, $CHF_2$-Gruppen, $CF_3$-Gruppen, CN-Gruppen, Thiogruppen und SCN-Gruppen; |
| $R^{10}$ | Alkyl, Aryl, Heteroaryl, Alkenyl, bevorzugt Alkyl, Heteroaryl oder Aryl, oder jeweils 2 Reste $R^{10}$ bilden gemeinsam einen anellierten Ring, der gegebenenfalls mindestens ein Heteroatom, bevorzugt N, enthalten kann, bevorzugt bilden jeweils 2 Reste $R^{10}$ gemeinsam einen anellierten aromatischen $C_6$-Ring, wobei an diesen, bevorzugt sechsgliedrigen, aromatischen Ring gegebenenfalls ein oder mehrere weitere aromatische Ringe anelliert sein können, wobei jede denkbare Anellierung möglich ist, und die anellierten Reste wiederum substituiert sein können; oder $R^{10}$ bedeutet einen Rest mit Donor- oder Akzeptorwirkung, bevorzugt ausgewählt aus Halogenresten, bevorzugt F, Cl, Br, besonders bevorzugt F; Alkoxy-, Aryloxy-, Carbonyl-, Ester-, Aminogruppen, Amidresten, $CHF_2$, $CH_2F$, $CF_3$, CN, Thiogruppen und SCN; |
| v | 0 bis 4, bevorzugt 0, 1 oder 2, ganz besonders bevorzugt 0, wobei, wenn v 0 ist, alle 4 möglichen Substituenten des Arylrests in Formel c Wasserstoffatome sind. |

Die Reste $Y^3$ und $Y^4$ wurden bereits vorstehend definiert.

Der mindestens eine Carbenligand in dem neutralen Übergangsmetall-Komplex der Formel I weist die folgende Formel (II) auf

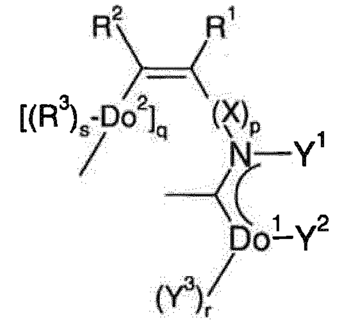 (II)

worin die Symbole die folgenden Bedeutungen aufweisen:

| | |
|---|---|
| $Do^1$ | Donoratom ausgewählt aus der Gruppe bestehend aus C, P, N, O und S, bevorzugt P, N, O und S, besonders bevorzugt N; |
| $Do^2$ | Donoratom ausgewählt aus der Gruppe bestehend aus C, N, P, O und S; |
| r | 2, wenn $Do^1$ C ist, 1, wenn $Do^1$ N oder P ist, und 0, wenn $Do^1$ O oder S ist; |
| s | 2, wenn $Do^2$ C ist, 1, wenn $Do^2$ N oder P ist und 0, wenn $Do^2$ O oder S ist; |

X Spacer ausgewählt aus der Gruppe bestehend aus Silylen, Alkylen, Arylen, Heteroarylen oder Alkenylen, bevorzugt Alkylen oder Arylen, besonders bevorzugt $C_1$- bis $C_3$-Alkylen oder $C_6$-1,4-Arylen, wobei gegebenenfalls mindestens eines der vier weiteren Kohlenstoffatome mit Methyl-, Ethyl-, n-Propyl- oder i-Propylgruppen oder mit Gruppen mit Donor- oder Akzeptorwirkung ausgewählt aus Halogenresten, bevorzugt F, Cl, Br, besonders bevorzugt F, Alkoxyresten, Aryloxyresten, Carbonyl-, Ester-, Aminogruppen, Amidresten, $CHF_2$, $CH_2F$, $CF_3$, CN, Thiogruppen und SCN substituiert sein kann, ganz besonders bevorzugt Methylen, Ethylen oder 1,4-Phenylen;

p 0 oder 1, bevorzugt 0;

q 0 oder 1, bevorzugt 0;

$Y^1$, $Y^2$ jeweils unabhängig voneinander Wasserstoff oder eine kohlenstoffhaltige Gruppe ausgewählt aus der Gruppe bestehend aus Alkyl-, Aryl-, Heteroaryl- und Alkenylgruppen; bevorzugt Alkyl-, Heteroaryl- und Arylgruppen; oder
$Y^1$ und $Y^2$ bilden gemeinsam eine Brücke zwischen dem Donoratom $Do^1$ und dem Stickstoffatom N, die mindestens zwei Atome, bevorzugt zwei bis drei Atome, besonders bevorzugt zwei Atome aufweist, wovon mindestens eines ein Kohlenstoffatom ist, wobei das mindestens eine weitere Atom bevorzugt ein Stickstoffatom ist, wobei die Brücke gesättigt oder ungesättigt, bevorzugt ungesättigt, sein kann und die mindestens zwei Atome der Brücke substituiert oder unsubstituiert sein können;

$Y^3$ ein Wasserstoff-, Alkyl-, Aryl-, Heteroaryl- oder Alkenylrest, bevorzugt ein Wasserstoff, ein Alkyl-, Heteroaryl- oder ein Arylrest oder

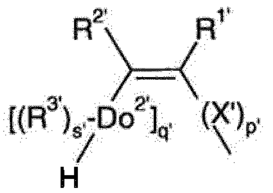

wobei $Do^{2'}$, q', s', $R^{3'}$, $R^{1'}$, $R^{2'}$, X' und p' unabhängig die gleichen Bedeutungen wie $Do^2$, q, s, $R^3$, $R^1$, $R^2$, X und p aufweisen;

$R^1$, $R^2$ unabhängig voneinander Wasserstoff, Alkyl-, Aryl-, Heteroaryl- oder Alkenylreste, bevorzugt Wasserstoff, Alkylreste, Heteroarylreste oder Arylreste; oder
$R^1$ und $R^2$ bilden gemeinsam eine Brücke mit insgesamt drei bis fünf, bevorzugt vier Atomen, wovon ein oder zwei Atome Heteroatome, bevorzugt N, sein können und die restlichen Atome Kohlenstoffatome sind, so dass die Gruppe

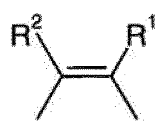

einen fünf- bis siebengliedrigen, bevorzugt sechsgliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen substituiert sein kann und gegebenenfalls Heteroatome, bevorzugt N, enthalten kann, wobei ein sechsgliedriger aromatischer Ring, der mit Alkyloder Arylgruppen substituiert oder unsubstituiert ist, bevorzugt ist, oder der bevorzugte sechsgliedrige aromatische Ring ist mit weiteren Ringen, die gegebenenfalls mindestens ein Heteroatom, bevorzugt N, enthalten können, bevorzugt sechsgliedrigen aromatischen Ringen anelliert;

$R^3$ Wasserstoff, ein Alkyl-, Aryl-, Heteroaryl- oder Alkenylrest, bevorzugt Wasserstoff, ein Alkyl-, Heteroaryl- oder ein Arylrest.

Bevorzugt sind solche Liganden der Formel II, worin p und/oder q 0 sind, d. h. dass in den Liganden der Formel

II keine Spacer X und/oder keine Donoratome $Do^2$ vorhanden sind.

Die Gruppierung

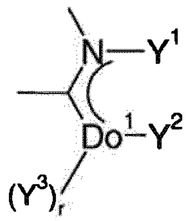

ist bevorzugt ausgewählt aus der Gruppe bestehend aus

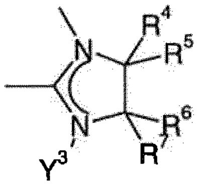

a

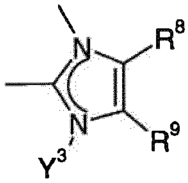

b

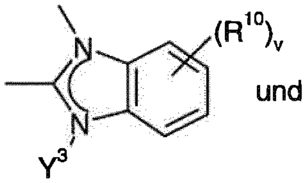

c

und

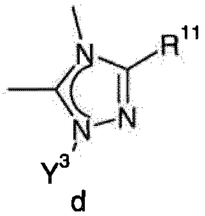

d

worin die Symbole die folgenden Bedeutungen aufweisen:

| | |
|---|---|
| $R^4$, $R^5$, $R^6$, $R^7$, $R^8$, $R^9$ und $R^{11}$ | Wasserstoff, Alkyl, Aryl, Heteroaryl, Alkenyl, oder ein Substituent mit Donor- oder Akzeptorwirkung ausgewählt aus Halogenresten, bevorzugt F, Cl, Br, besonders bevorzugt F, Alkoxyresten, Aryloxyresten, Carbonylresten, Esterresten, Aminresten, Amidresten, $CH_2F$-Grupen, $CHF_2$-Gruppen, $CF_3$-Gruppen, CN-Gruppen, Thiogruppen und SCN-Gruppen, bevorzugt Wasserstoff, Alkyl, Heteroaryl oder Aryl; |
| $R^{10}$ | Alkyl, Aryl, Heteroaryl, Alkenyl, bevorzugt Alkyl oder Aryl, oder jeweils 2 Reste $R^{10}$ bilden gemeinsam einen anellierten Ring, der gegebenenfalls mindestens ein Heteroatom, bevorzugt N, enthalten kann, bevorzugt bilden jeweils 2 Reste $R^{10}$ gemeinsam einen anellierten aromatischen $C_6$-Ring, wobei an diesen, bevorzugt sechsgliedrigen, aromatischen Ring gegebenenfalls ein oder mehrere weitere aromatische Ringe anelliert sein können, wobei jede denkbare Anellierung möglich ist, und die anellierten Reste wiederum substituiert sein können; oder $R^{10}$ bedeutet einen Rest mit Donoroder Akzeptorwirkung, bevorzugt ausgewählt aus der Gruppe bestehend aus Halogenresten, bevorzugt F, Cl, Br, besonders bevorzugt F; Alkoxy-, Aryloxy-, Carbonyl-, Ester-, Aminogruppen, Amidresten, $CHF_2$, $CH_2F$, $CF_3$, CN, Thiogruppen und SCN; |
| v | 0 bis 4, bevorzugt 0, 1 oder 2, ganz besonders bevorzugt 0, wobei, wenn v 0 ist, die vier Kohlenstoffatome des Arylrests in Formel c, die gegebenenfalls mit $R^{10}$ substituiert sind, Wasserstoffatome tragen; |

$Y^3$ wurde bereits vorstehend definiert.

Die Gruppierung

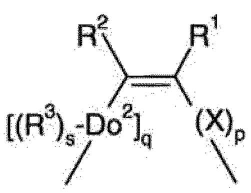

des Carbenliganden der Formel II bedeutet bevorzugt

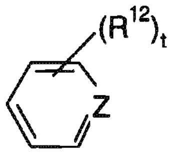

worin die Symbole die folgenden Bedeutungen aufweisen:

Z CH oder N, wobei Z in o-, m- oder p-Position zur Verknüpfungsstelle der Gruppierung mit dem Carbenliganden angeordnet sein kann;

$R^{12}$ ein Alkyl-, Aryl-, Heteroaryl- oder Alkenylrest, bevorzugt ein Alkyl- oder Arylrest, oder jeweils 2 Reste $R^{12}$ bilden gemeinsam einen anellierten Ring, der gegebenenfalls mindestens ein Heteroatom, bevorzugt N, enthalten kann, bevorzugt bilden jeweils 2 Reste $R^{12}$ gemeinsam einen anellierten aromatischen $C_6$-Ring, wobei an diesen, bevorzugt sechsgliedrigen, aromatischen Ring gegebenenfalls ein oder mehrere weitere aromatische Ringe anelliert sein können, wobei jede denkbare Anellierung möglich ist, und die anellierten Reste wiederum substituiert sein können; oder $R^{12}$ bedeutet einen Rest mit Donor- oder Akzeptorwirkung, bevorzugt ausgewählt aus der Gruppe bestehend aus Halogenresten, bevorzugt F, Cl, Br, besonders bevorzugt F; Alkoxy-, Aryloxy-, Carbonyl-, Ester-, Aminogruppen, Amidresten, $CHF_2$, $CH_2F$, $CF_3$, CN, Thiogruppen und SCN;

t 0 bis 3, wobei, wenn t > 1 ist, die Reste $R^{12}$ gleich oder verschieden sein können, bevorzugt ist t 0 oder 1, der Rest $R^{12}$ befindet sich, wenn 11 ist, in ortho-, meta- oder para-Position zur Verknüpfungsstelle mit dem Spacer X, bzw., wenn p 0 ist, zur Verknüpfungsstelle mit dem dem Carbenkohlenstoffatom benachbarten Stickstoffatom.

In den Carbenliganden der Formel II kann $Y^3$ gleich oder verschieden von der vorstehend definierten Gruppierung sein und die folgenden, bereits vorstehend erwähnten Bedeutungen aufweisen:

ein Wasserstoff-, Alkyl-, Aryl-, Heteroaryl- oder Alkenylrest, bevorzugt ein Wasserstoff,
ein Alkyl-, Heteroaryl- oder ein Arylrest
oder

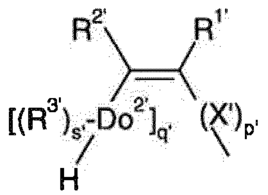

wobei $Do^{2'}$, q', s', $R^{3'}$, $R^{1'}$, $R^{2'}$, X' und p' unabhängig die gleichen Bedeutungen wie $Do^2$, q, s, $R^3$, $R^1$, $R^2$, X und p aufweisen.

Neben Carbenliganden der Formel II, worin $Y^4$, das heißt die Gruppe der Formel

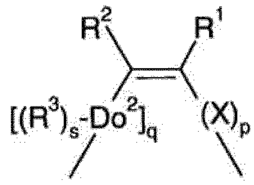

die Struktur

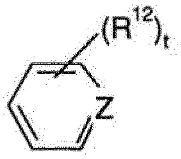

bedeutet

und $Y^3$

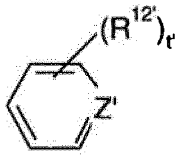

bedeutet,
sind Carbenliganden geeignet, worin $Y^4$, das heißt die Gruppe der Formel

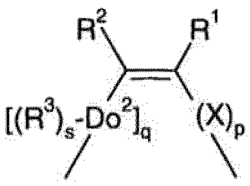

die Struktur

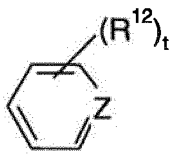

bedeutet
und $Y^3$
ein Wasserstoff-, Alkyl-, Aryl-, Heteroaryl- oder Alkenylrest, bevorzugt ein Wasserstoff, ein Alkyl-, Heteroaryl- oder ein Arylrest
bedeutet.

Die Definitionen der Symbole entsprechen den vorstehend genannten Definitionen.

Ganz besonders bevorzugt ist der mindestens eine Carbenligand der Formel II ausgewählt aus der Gruppe bestehend aus

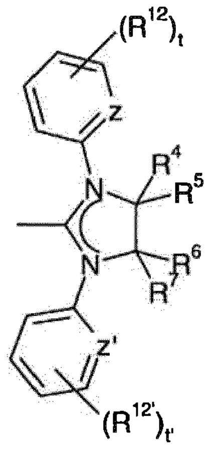

a

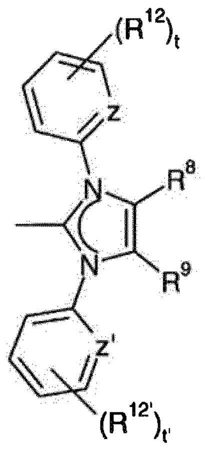

b

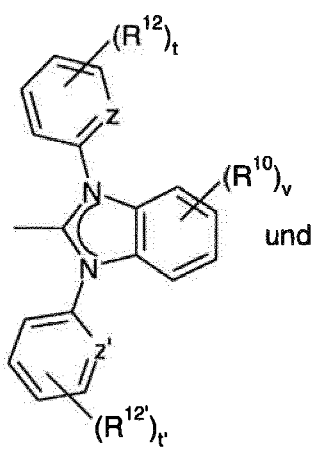

c

und

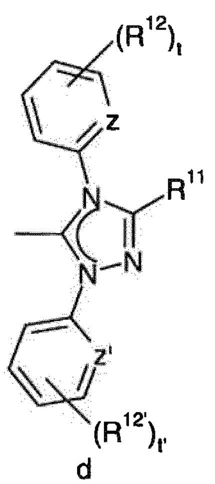

d

worin die Symbole die folgenden Bedeutungen aufweisen:

| | |
|---|---|
| Z, Z' | gleich oder verschieden, CH oder N; |
| $R^{12}$, $R^{12'}$ | gleich oder verschieden, ein Alkyl-, Aryl-, Heteroaryl- oder Alkenylrest, bevorzugt ein Alkyl- oder Arylrest oder jeweils 2 Reste $R^{12}$ bzw. $R^{12'}$ bilden gemeinsam einen anellierten Ring, der gegebenenfalls mindestens ein Heteroatom, bevorzugt N, enthalten kann, bevorzugt bilden jeweils 2 Reste $R^{12}$ bzw. $R^{12'}$ gemeinsam einen anellierten aromatischen $C_6$-Ring, wobei an diesen, bevorzugt sechsgliedrigen, aromatischen Ring gegebenenfalls ein oder mehrere weitere aromatische Ringe anelliert sein können, wobei jede denkbare Anellierung möglich ist, und die anellierten Reste wiederum substituiert sein können; oder $R^{12}$ bzw. $R^{12'}$ bedeutet einen Rest mit Donor- oder Akzeptorwirkung, bevorzugt ausgewählt aus der Gruppe bestehend aus Halogenresten, bevorzugt F, Cl, Br, besonders bevorzugt F; Alkoxy-, Aryloxy-, Carbonyl-, Ester-, Aminogruppen, Amidresten, $CHF_2$, $CH_2F$, $CF_3$, CN, Thiogruppen und SCN; |
| t und t' | gleich oder verschieden, bevorzugt gleich, 0 bis 3, wobei, wenn t bzw. t' > 1 ist, die Reste $R^{12}$ bzw. $R^{12'}$ gleich oder verschieden sein können, bevorzugt ist t bzw. t' 0 oder 1, der Rest $R^{12}$ bzw. $R^{12'}$ befindet sich, wenn t bzw. t' 1 ist, in ortho-, meta- oder para-Position zur Verknüpfungsstelle mit dem dem Carbenkohlenstoffatom benachbarten Stickstoffatom; |
| $R^4$, $R^5$, $R^6$, $R^7$, $R^8$, $R^9$ und $R^{11}$ | Wasserstoff, Alkyl, Aryl, Heteroaryl, Alkenyl oder ein Substituent mit Donor- oder Akzeptorwirkung, bevorzugt ausgewählt aus Halogenresten, bevorzugt F, Cl, Br, besonders bevorzugt F, Alkoxyresten, Aryloxyresten, Carbonylresten, Esterresten, Aminresten, Amidresten, $CH_2F$-Gruppen, $CHF_2$-Gruppen, $CF_3$-Gruppen, CN-Gruppen, Thiogruppen und SCN-Gruppen, bevorzugt Wasserstoff, Alkyl, Heteroaryl oder Aryl, |
| $R^{10}$ | Alkyl, Aryl, Heteroaryl oder Alkenyl, bevorzugt Alkyl, Heteroaryl oder Aryl, oder jeweils 2 Reste $R^{10}$ bilden gemeinsam einen anellierten Ring, der gegebenenfalls mindestens ein Heteroatom, bevorzugt Stickstoff, enthalten kann, bevorzugt bilden jeweils 2 Reste $R^{10}$ gemeinsam einen anellierten aromatischen $C_6$-Ring, wobei an diesen, bevorzugt sechsgliedrigen, aromatischen Ring gegebenenfalls ein oder mehrere weitere aromatische Ringe anelliert sein können, wobei jede denkbare Anellierung möglich ist, und die anellierten Reste wiederum substituiert sein können; oder $R^{10}$ bedeutet einen Rest mit Donor- oder Akzeptorwirkung, bevorzugt ausgewählt aus der Gruppe bestehend aus Halogenresten, bevorzugt F, Cl, Br, besonders bevorzugt F; Alkoxy-, Aryloxy-, Carbonyl-, Ester-, Aminogruppen, Amidresten, $CHF_2$, $CH_2F$, $CF_3$, CN, Thiogruppen und SCN |

v 0 bis 4, bevorzugt 0, 1 oder 2, ganz besonders bevorzugt 0, wobei, wenn v 0 ist, die vier Kohlenstoffatome des Arylrests in Formel c, die gegebenenfalls mit $R^{10}$ substituiert sind, Wasserstoffatome tragen.

Somit sind in der Erfindung verwendete Übergangsmetall-Komplexe solche, die die allgemeine Formel (IB) aufweisen

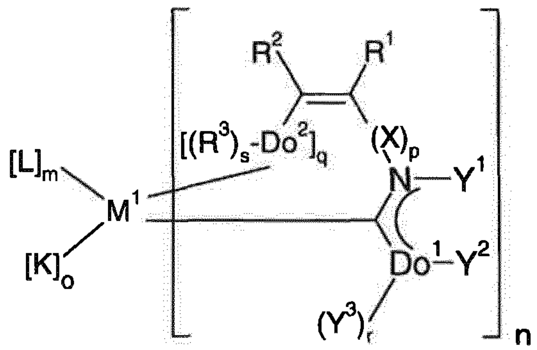

(IB)

Die Bedeutungen der Symbole entsprechen den vorstehend bezüglich des Übergangsmetallkomplexes (I) und bezüglich des Carbenliganden (II) genannten Bedeutungen. Bevorzugte Ausführungsformen sind ebenfalls vorstehend genannt.

Die Übergangsmetall-Komplexe der Formel IB können - wenn ein Metallatom $M^1$ mit der Koordinationszahl 6 eingesetzt wird - als faciales oder meridionales Isomer oder Isomerengemisch aus facialem und meridionalem Isomer in beliebigen Mengenverhältnissen vorliegen, wenn sie eine Zusammensetzung $MA_3B_3$ - wie vorstehend ausgeführt - aufweisen. In Abhängigkeit von den Eigenschaften des facialen oder meridionalen Isomeren der Übergangsmetall-Komplexe der Formel IB kann es bevorzugt sein, entweder ein isomerenreines faciales oder ein isomerenreines meriodionales Isomer einzusetzen oder ein Isomerengemisch aus facialem und meridionalem Isomer, worin eines der Isomere im Überschuss vorliegt oder beide Isomere in gleicher Menge vorliegen. Beispielsweise sind faciale und meridionale Isomere des Übergangsmetallkomplexes der Formel IB möglich, wenn n 3 bedeutet und m und o 0 bedeuten. Für den Fall, dass die Übergangsmetall-Komplexe der Formel IB eine Zusammensetzung $MA_2B_4$ aufweisen, können die Übergangsmetallkomplexe in Form von cis/trans Isomeren in beliebigen Mengenverhältnissen vorliegen, wie vorstehend ausgeführt. In Abhängigkeit von den Eigenschaften des cis oder trans Isomeren der Übergangsmetall-Komplexe der Formel IB kann es bevorzugt sein, entweder ein isomerenreines cis oder ein isomerenreines trans Isomer einzusetzen oder ein Isomerengemisch aus cis und trans Isomer, worin eines der Isomere im Überschuss vorliegt oder beide Isomere in gleicher Menge vorliegen. Cis/trans-Isomere von Komplexen der Formel IB sind zum Beispiel möglich, wenn $M^1$ ein Metallatom mit der Koordinationszahl 6 ist und wenn n 2 bedeutet und m 2 bedeutet, wobei die beiden monodentaten Liganden L gleich sind, und o 0 ist, oder wenn o 2 bedeutet und die beiden monodentaten Liganden K gleich sind, und m 0 ist.

Für neutrale Übergangsmetallkomplexe, worin das Übergangsmetallatom Ir(III) mit einer Koordinationszahl von 6 ist, ist die Zahl der bevorzugten monoanionischen bidentaten Carbenliganden n mindestens 1 und maximal 3. Bevorzugt ist die Zahl der bevorzugt eingesetzten monanionischen bidentaten Carbenliganden 2 oder 3, besonders bevorzugt 3. Dabei können die Carbenliganden bei n > 1 gleich oder verschieden sein.

Die Übergangsmetall-Komplexe der Formel IB können - wenn ein Metallatom $M^1$ mit der Koordinationszahl 4 eingesetzt wird, das quadratisch planare Komplexe bildet - als cis- oder trans-Isomere oder als Isomerengemisch aus cis- oder trans-Isomeren in beliebigen Mengenverhältnissen vorliegen, wenn sie eine Zusammensetzung $MA_2B_2$ - wie vorstehend ausgeführt - aufweisen. Beispielsweise sind cis/trans-Isomere der Übergangsmetall-Komplexe der Formel IB möglich, wenn n 2 bedeutet und m und o 0 bedeuten.

Für neutrale Übergansmetallkomplexe, worin das Übergangsmetallatom Pt(II) mit einer Koordinationszahl von 4 ist, ist die Zahl n der bevorzugten monoanionischen bidentaten Carbenliganden n 1 oder 2, bevorzugt 2. Dabei können die Carbenliganden bei n = 2 gleich oder verschieden sein.

Ganz besonders bevorzugt ist ein Übergangsmetallkomplex, worin $M^1$ Ir(III) ist, das eine Koordinationszahl von 6 aufweist. Ganz besonders bevorzugt ist n in diesem Ir(III)-Komplex 3, m 0, o 0, q 0, p 0, $Do^1$ N und r 1, wobei die übrigen Symbole die bereits vorstehend genannten Bedeutungen aufweisen.

insbesondere bevorzugt sind Übergangsmetallkomplexe der Formel IBa bis d ausgewählt aus der Gruppe bestehend aus

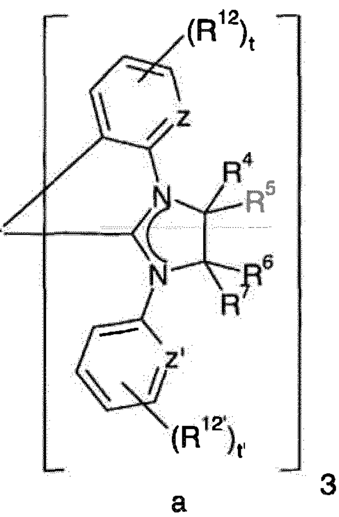

a

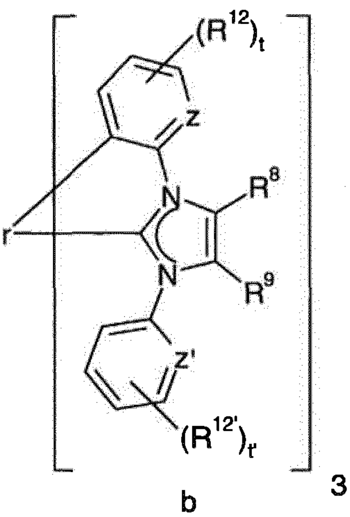

b

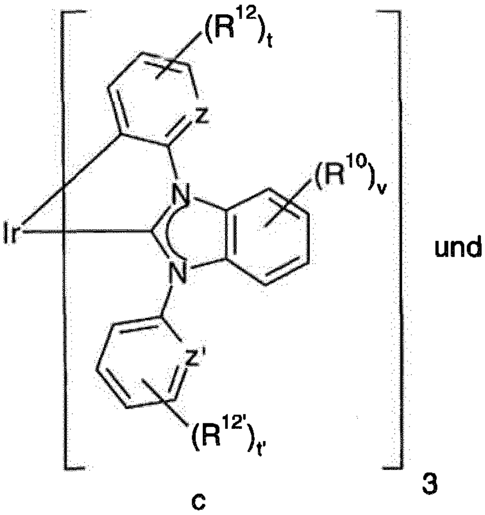

c

und

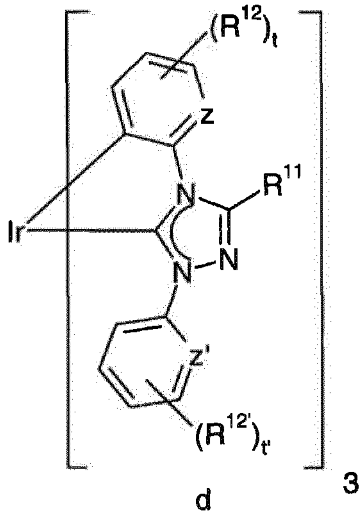

d

worin die Symbole die bereits vorstehend bezüglich der bevorzugt geeigneten Carbenliganden genannten Bedeutungen aufweisen.

Ganz besonders bevorzugt sind unter diesen Ir(III)-Komplexen solche der Formeln b, c und d. Insbesondere bevorzugt sind solche Ir(III)-Komplexe, worin Z und Z' CH, $R^8$ und $R^9$H, t, t' und v 0 bedeuten und die übrigen Reste die bereits vorstehend bezüglich der bevorzugt geeigneten Carbenliganden genannten Bedeutungen aufweisen.

Die vorstehend genannten neutralen Übergangsmetall-Komplexe sind hervorragend als Emittermoleküle in organischen Licht-emittierenden Dioden (OLEDs) geeignet. Durch einfache Variationen der Liganden oder des Zentralmetalls ist es möglich, Übergangsmetall-Komplexe bereit zu stellen, die Elektrolumineszenz im roten, grünen sowie insbesondere im blauen Bereich des elektromagnetischen Spektrums zeigen. Die erfindungsgemäß verwendeten neutralen Übergangsmetall-Komplexe eignen sich daher für den Einsatz in technisch verwendbaren Vollfarbendisplays.

Des Weiteren sind die vorstehend genannten neutralen Übergangsmetallkomplexe als Elektronen-, Excitonen- oder Lochblocker in OLEDs geeignet, in Abhängigkeit von den eingesetzten Liganden und dem eingesetzten Zentralmetall.

Ein weiterer Gegenstand der vorliegenden Anmeldung sind OLEDs umfassend neutrale Übergangsmetall-Komplexe der allgemeinen Formel IC

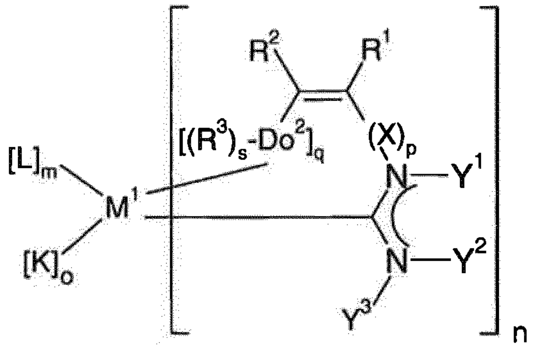

(IC)

worin die Symbole die folgenden Bedeutungen aufweisen:

$M^1$ Ir, Pt in jeder für das entsprechende Metallatom möglichen Oxidationsstufe;

L mono- oder dianionischer Ligand, bevorzugt monoanionischer Ligand, der mono- oder bidentat sein kann;

K neutraler mono- oder bidentater Ligand wie oben definiert;

n Zahl der Carbenliganden, wobei n mindestens 2 ist und die Carbenliganden in dem Übergangsmetall-Komplex gleich oder verschieden sein können;

m Zahl der Liganden L, wobei m 0 oder $\geq 1$ sein kann und die Liganden L bei $m > 1$ gleich oder verschieden sein können;

o Zahl der Liganden K, wobei o 0 oder $\geq 1$ sein kann und die Liganden K bei $o > 1$ gleich oder verschieden sein können;

wobei die Summe n + m + o von der Oxidationsstufe und Koordinationszahl des eingesetzten Metallatoms und der Zähnigkeit der Liganden sowie von der Ladung der Liganden abhängig ist, mit der Bedingung, dass n mindestens 2 ist;

$Do^2$ Donoratom ausgewählt aus der Gruppe bestehend aus C, N, P, O und S;

s 2, wenn $Do^2$ C ist, 1, wenn $Do^2$ N oder P ist und 0, wenn $Do^2$ O oder S ist;

X Spacer ausgewählt aus der Gruppe bestehend aus Silylen, Alkylen, Arylen, Heteroarylen oder Alkenylen, bevorzugt Alkylen oder Arylen, besonders bevorzugt $C_1$- bis $C_3$-Alkylen oder $C_6$-1,4-Arylen, wobei gegebenenfalls mindestens eines der vier weiteren Kohlenstoffatome mit Methyl-, Ethyl-, n-Propyl- oder i-Propylgruppen oder mit Gruppen mit Donor- oder Akzeptorwirkung ausgewählt aus Halogenresten, bevorzugt F, Cl, Br, besonders bevorzugt F; Alkoxy-, Aryloxy-, Carbonyl-, Ester-, Aminogruppen, Amidresten, $CHF_2$, $CH_2F$, $CF_3$, CN, Thiogruppen und SCN substituiert sein kann; ganz besonders bevorzugt Methylen, Ethylen oder 1,4-Phenylen;

p 0 oder 1, bevorzugt 0;

q 0 oder 1, bevorzugt 0;

$Y^3$ ein Wasserstoff-, Alkyl-, Aryl-, Heteroaryl- oder Alkenylrest, bevorzugt ein Wasserstoff, ein Alkyl- oder ein Arylrest, oder

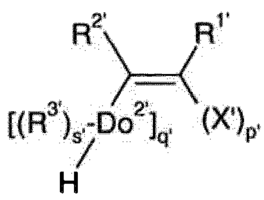

wobei $Do^{2'}$, q', s', $R^{3'}$, $R^{1'}$, $R^{2'}$, X' und p' unabhängig die gleichen Bedeutungen wie $Do^2$, q, s, $R^3$, $R^1$, $R^2$, X und p aufweisen;

$R^1$, $R^2$ unabhängig voneinander Wasserstoff, Alkyl-, Aryl-, Heteroaryl- oder Alkenylreste, bevorzugt Wasserstoff, Alkylreste oder Arylreste, oder
$R^1$ und $R^2$ bilden gemeinsam eine Brücke mit insgesamt drei bis fünf, bevorzugt vier Atomen, wovon ein oder zwei Atome Heteroatome, bevorzugt N, sein können und die restlichen Atome Kohlenstoffatome sind, so dass die Gruppe

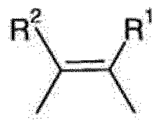

einen fünf- bis siebengliedrigen, bevorzugt sechsgliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl-, Heteroaryl-, oder Arylgruppen substituiert sein kann und gegebenenfalls mindestens ein Heteroatom, bevorzugt N, enthalten kann, wobei ein sechsgliedriger aromatischer Ring, der mit Alkyl- oder Arylgruppen substituiert oder unsubstituiert ist, bevorzugt ist, oder der bevorzugte sechsgliedrige aromatische Ring ist mit weiteren Ringen, bevorzugt sechsgliedrigen aromatischen Ringen, die gegebenenfalls mindestens ein Heteroatom, bevorzugt N, enthalten können, anelliert;

$R^3$ Wasserstoff, ein Alkyl-, Aryl-, Heteroaryl- oder Alkenylrest, bevorzugt Wasserstoff, ein Alkyl-, Heteroaryl- oder ein Arylrest,

$Y^1$, $Y^2$ bilden gemeinsam eine Brücke zwischen den Stickstoffatomen N, die mindestens zwei Atome aufweist, wovon mindestens eines ein Kohlenstoffatom ist, und die weiteren Atome bevorzugt Stickstoff- oder Kohlenstoffatome sind, wobei die Brücke gesättigt oder ungesättigt sein kann und die mindestens zwei Atome der Brücke substituiert oder unsubstituiert sein können, wobei - für den Fall, dass die Brücke zwei Kohlenstoffatome aufweist und gesättigt ist - mindestens eines der zwei Kohlenstoffatome substituiert ist; bevorzugt weist die Brücke zwei Atome auf, wobei die beiden Atome substituiert sein können, und ist ungesättigt.

Bevorzugte und ganz besonders bevorzugte Ausführungsformen der Symbole in dem Übergangsmetallkomplex der Formel IC sind bereits vorstehend bezüglich der erfindungsgemäß verwendeten Übergangsmetallkomplexe genannt.

In Abhängigkeit von dem Substitutionsmuster an dem Zentralmetall $M^1$ und bei Einsatz eines Zentalmetalls der Koordinationszahl 6, zum Beispiel Ir(III), können die oktaedrischen Übergangsmetallkomplexe in Form ihrer facialen oder meridionalen Isomere oder als Gemisch von facialen und meridionalen Isomeren in beliebigen Mengenverhältnissen vorliegen. Die Voraussetzungen zur Ausbildung facialer und meridionaler Isomere wurden bereits vorstehend erläutert. Gegenstand der vorliegenden Anmeldung sind somit ebenfalls - neben fac-mer-Isomerengemischen - OLEDs umfassend die reinen facialen oder meridionalen Isomere der Übergangsmetall-Komplexe IC, soweit diese aufgrund des Substitutionsmusters an dem eingesetzten Zentralmetall vorliegen können. In Abhängigkeit von den Eigenschaften des facialen oder meridionalen Isomeren der Übergangsmetall-Komplexe der Formel IC kann es bevorzugt sein, entweder ein isomerenreines faciales oder ein isomerenreines meriodionales Isomer einzusetzen oder ein Isomerengemisch aus facialem und meridionalem Isomer, worin eines der Isomere im Überschuss vorliegt oder beide Isomere in gleicher Menge vorliegen. Die einzelnen Isomere können aus dem entsprechenden Isomerengemisch zum Beispiel durch Chromatographie, Sublimation oder Kristallisation isoliert werden. Entsprechende Verfahren zur Trennung der Isomere sind dem Fachmann bekannt.

Bevorzugt ist die Gruppierung

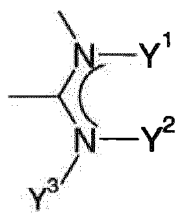

in dem Übergangsmetall-Komplex IC ausgewählt aus der Gruppe bestehend aus

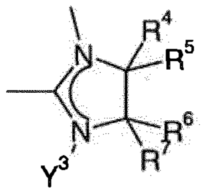 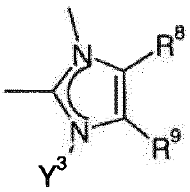 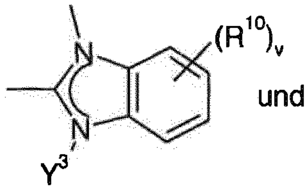 und 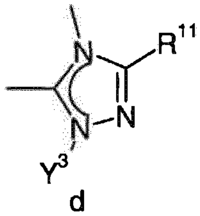

a b c d

worin die Symbole die folgenden Bedeutungen aufweisen:

$R^4$, $R^5$, $R^6$, $R^7$, $R^8$, $R^9$ und $R^{11}$ unabhängig voneinander Wasserstoff, Alkyl, Aryl, Heteroaryl, Alkenyl oder ein Substituent mit Donor- oder Akzeptorwirkung, bevorzugt ausgewählt aus Halogenresten, bevorzugt F, Cl, Br, besonders bevorzugt F, Alkoxyresten, Aryloxyresten, Carbonylresten, Esterresten, Aminresten, Amidresten, $CH_2F$-Grupen, $CHF_2$-Gruppen, $CF_3$-Gruppen, CN-Gruppen, Thiogruppen und SCN-Gruppen, bevorzugt Wasserstoff, Alkyl oder Aryl; wobei in Formel a mindestens einer der Reste $R^4$, $R^5$, $R^6$ oder $R^7$ nicht Wasserstoff bedeutet;

$R^{10}$ Alkyl, Aryl, Heteroaryl, Alkenyl, bevorzugt Alkyl oder Aryl, oder jeweils 2 Reste $R^{10}$ bilden gemeinsam einen anellierten Ring, der gegebenenfalls mindestens ein Heteroatom, bevorzugt Stickstoff, enthalten kann, bevorzugt bilden jeweils 2 Reste $R^{10}$ gemeinsam einen anellierten aromatischen $C_6$-Ring, wobei an diesen, bevorzugt sechsgliedrigen, aromatischen Ring gegebenenfalls ein oder mehrere weitere aromatische Ringe anelliert sein können, wobei jede denkbare Anellierung möglich ist, und die anellierten Reste wiederum substituiert sein können; oder $R^{10}$ bedeutet einen Rest mit Donor- oder Akzeptorwirkung, bevorzugt ausgewählt aus der Gruppe bestehend aus Halogenresten, bevorzugt F, Cl, Br, besonders bevorzugt F; Alkoxy-, Aryloxy-, Carbonyl-, Ester-, Aminogruppen, Amidresten, $CHF_2$, $CH_2F$, $CF_3$, CN, Thiogruppen und SCN;

v 0 bis 4, bevorzugt 0, 1 oder 2, ganz besonders bevorzugt 0, wobei, wenn v 0 ist, die vier Kohlenstoffatome des Arylrests in Formel c, die gegebenenfalls mit $R^{10}$ substituiert sind, Wasserstoffatome tragen;

$Y^3$ wurde bereits vorstehend definiert.

Die Gruppierung

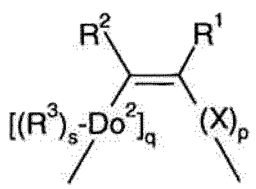

bedeutet bevorzugt

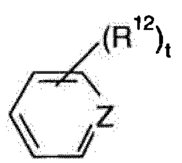

worin die Symbole die folgenden Bedeutungen aufweisen:

Z CH oder N, wobei Z in o-, m- oder p-Position zur Verknüpfungsstelle der Gruppierung mit dem Carbenliganden angeordnet sein kann;

$R^{12}$ ein Alkyl-, Aryl-, Heteroaryl-, Alkenylrest, bevorzugt ein Alkyl- oder Arylrest oder jeweils 2 Reste $R^{12}$ bilden gemeinsam einen anellierten Ring, der gegebenenfalls mindestens ein Heteroatom, bevorzugt N, enthalten kann, bevorzugt bilden jeweils 2 Reste $R^{12}$ gemeinsam einen anellierten aromatischen $C_6$-Ring, wobei an diesen, bevorzugt sechsgliedrigen, aromatischen Ring gegebenenfalls ein oder mehrere weitere aromatische Ringe anelliert sein können, wobei jede denkbare Anellierung möglich ist, und die anellierten Reste wiederum substituiert sein können; oder $R^{12}$ bedeutet einen Rest mit Donor- oder Akzeptorwirkung, bevorzugt ausgewählt aus der Gruppe bestehend aus Halogenresten, bevorzugt F, Cl, Br, besonders bevorzugt F; Alkoxy-, Aryloxy-, Carbonyl-, Ester-, Aminogruppen, Amidresten, $CHF_2$, $CH_2F$, $CF_3$, CN, Thiogruppen und SCN;

t 0 bis 3, wobei, wenn t > 1 ist, die Reste $R^{12}$ gleich oder verschieden sein können, bevorzugt ist t 0 oder 1, der Rest $R^{12}$ befindet sich, wenn 11 ist, in ortho-, meta- oder para-Position zur Verknüpfungsstelle mit dem Spacer X, bzw., wenn p 0 ist, zur Verknüpfungsstelle mit dem dem Carbenkohlenstoffatom benachbarten Stickstoffatom.

$Y^3$ kann gleich oder verschieden von der vorstehend definierten Gruppierung sein.

Besonders bevorzugt weist der Übergangsmetall-Komplex mindestens zwei Carbenliganden auf, die unabhängig voneinander ausgewählt sind aus der Gruppe bestehend aus

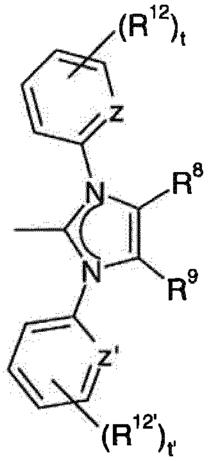

b

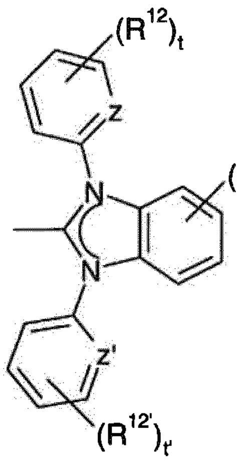

c

und

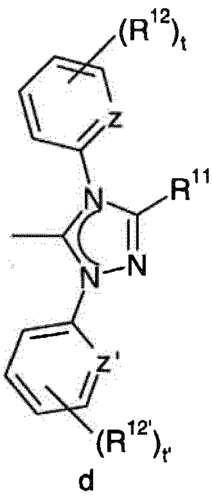

d

worin die Symbole die folgenden Bedeutungen aufweisen:

Z, Z' gleich oder verschieden, bevorzugt gleich, CH oder N;

$R^{12}$, $R^{12'}$ gleich oder verschieden, bevorzugt gleich, ein Alkyl-, Aryl-, Heteroaryl-, Alkenylrest, bevorzugt ein Alkyl-, Heteroaryl- oder Arylrest oder jeweils 2 Reste $R^{12}$ bzw. $R^{12'}$ bilden gemeinsam einen anellierten Ring, der gegebenenfalls mindestens ein Heteroatom, bevorzugt N, enthalten kann, bevorzugt bilden jeweils 2 Reste $R^{12}$ bzw. $R^{12'}$ gemeinsam einen anellierten aromatischen $C_6$-Ring, wobei an diesen, bevorzugt sechsgliedrigen, aromatischen Ring gegebenenfalls ein oder mehrere weitere aromatische Ringe anelliert sein können, wobei jede denkbare Anellierung möglich ist, und die anellierten Reste wiederum substituiert sein können; oder $R^{12}$ bzw. $R^{12'}$ bedeutet einen Rest mit Donor- oder Akzeptorwirkung, bevorzugt ausgewählt aus der Gruppe bestehend aus Halogenresten, bevorzugt F, Cl, Br, besonders bevorzugt F; Alkoxy-, Aryloxy-, Carbonyl-, Ester-, Aminogruppen, Amidresten, $CHF_2$, $CH_2F$, $CF_3$, CN, Thiogruppen und SCN;

t und t' gleich oder verschieden, bevorzugt gleich, 0 bis 3, wobei, wenn t bzw. t' > 1 ist, die Reste $R^{12}$ bzw. $R^{12'}$ gleich oder verschieden sein können, bevorzugt ist t bzw. t' 0 oder 1, der Rest $R^{12}$ bzw. $R^{12'}$ befindet sich, wenn t bzw. t' 1 ist, in ortho-, meta- oder para-Position zur Verknüpfungsstelle mit dem dem Carbenkohlenstoffatom benachbarten Stickstoffatom;

$R^8$, $R^9$ und $R^{11}$ Wasserstoff, Alkyl, Aryl, Heteroaryl, Alkenyl, oder ein Substituent mit Donoroder Akzeptorwirkung, bevorzugt ausgewählt aus Halogenresten, bevorzugt F, Cl, Br, besonders bevorzugt F, Alkoxyresten, Aryloxyresten, Carbonylresten, Esterresten, Aminresten, Amidresten, $CH_2F$-Grupen, $CHF_2$-Gruppen, $CF_3$-Gruppen, CN-Gruppen, Thiogruppen und SCN-Gruppen, bevorzugt Wasserstoff, Alkyl oder Aryl;

$R^{10}$ Alkyl, Aryl, Heteroaryl, Alkenyl, bevorzugt Alkyl, Heteroaryl oder Aryl, oder jeweils 2 Reste $R^{10}$ bilden gemeinsam einen anellierten Ring, der gegebenenfalls mindestens ein Heteroatom, bevorzugt N, enthalten kann, bevorzugt bilden jeweils 2 Reste $R^{10}$ gemeinsam einen anellierten aromatischen $C_6$-Ring, wobei an diesen, bevorzugt sechsgliedrigen, aromatischen Ring gegebenenfalls ein oder mehrere weitere aromatische Ringe anelliert sein können, wobei jede denkbare Anellierung möglich ist, und die anellierten Reste wiederum substituiert sein können; oder $R^{10}$ bedeutet einen Rest mit Donor- oder Akzeptorwirkung, bevorzugt ausgewählt aus der Gruppe bestehend aus Halogenresten, bevorzugt F, Cl, Br, besonders bevorzugt F; Alkoxy-, Aryloxy-, Carbonyl-, Ester-, Aminogruppen, Amidresten, $CHF_2$, $CH_2F$, $CF_3$, CN, Thiogruppen und SCN;

v 0 bis 4, bevorzugt 0, 1 oder 2, ganz besonders bevorzugt 0, wobei, wenn v 0 ist, die vier Kohlenstoffatome des Arylrests in Formel c, die gegebenenfalls mit $R^{10}$ substituiert sind, Wasserstoffatome tragen.

Besonders bevorzugt weisen die Übergangsmetallkomplexe der allgemeinen Formel IC ein Metallatom $M^1$ ausgewählt aus der Gruppe bestehend aus Pt(II) und Ir(III) auf. Besonders bevorzugt wird als Metallatom $M^1$ Ir eingesetzt, bevorzugt Ir(III).

In einer ganz besonders bevorzugten Ausführungsform ist $M^1$ in den Übergangsmetallkomplexen Ir(III), n 3 und m und o 0, wobei besonders bevorzugt die drei Carbenliganden gleich sind.

Die Übergangsmetall-Komplexe der Formel IC können analog zu dem Fachmann bekannten Verfahren hergestellt werden. Geeignete Herstellungsverfahren sind zum Beispiel in den Übersichtsartikeln W. A. Hermann et al., Advances in Organometallic Chemistry, Vol. 48, 1 bis 69, W. A. Hermann et al., Angew. Chem. 1997, 109, 2256 bis 2282 und G. Bertrand et al. Chem. Rev. 2000, 100, 39 bis 91 und der darin zitierten Literatur aufgeführt.

In einer Ausführungsform werden die Übergangsmetallkomplexe durch Deprotonierung von den den entsprechenden Carbenliganden entsprechenden Ligandvorläufern und anschließende Umsetzung mit geeigneten, das gewünschte Metall enthaltenden, Metallkomplexen hergestellt. Daneben ist die Herstellung der Übergangsmetallkomplexe durch direkte Verwendung von Wanzlick-Olefinen möglich.

Geeignete Ligandvorläufer sind dem Fachmann bekannt. Bevorzugt handelt es sich um kationische Vorstufen.

In einer bevorzugten Ausführungsform werden die kationischen Vorstufen deprotoniert, wobei je nach Vorläufer unterschiedliche Zwischenprodukte entstehen können. Je nach Reaktionsführung entstehen so beispielsweise Alkoxid-Derivate, dimere Wanzlick-Olefine oder die freien N-Heterocyclencarbene. Alkoxid-Derivate und Wanzlick-Olefine werden vorzugsweise in Gegenwart einer geeigneten Metallvorstufe thermisch belastet, wobei eine Abspaltung des Alkohols bzw. die Spaltung des Dimeren erfolgt und die Metallcarben-Verbindung in Anwesenheit von geeigneten Metallkomplexen gebildet wird. Wird als Zwischenprodukt das freie Carben gebildet, wird die Reaktion vorzugsweise unter Kühlung und anschließendem Erwärmen auf Raumtemperatur bzw. falls notwendig weiteres Erhitzen durchgeführt. Die Umsetzungen sind vorzugsweise in geeigneten Lösungsmitteln durchzuführen, wobei bei zweistufigen Varianten für beide Teilschritte das gleiche oder unterschiedliche Lösungsmittel verwendet werden können. Geeignete Lösungsmittel sind zum Beispiel aromatische und aliphatische Lösungsmittel oder Ether, zum Beispiel Toluol, Tetrahydrofuran. Soweit nicht mit freien Carbenen gearbeitet wird, können auch Alkohole oder chlorierte Kohlenwasserstoffe wie Methylenchlorid eingesetzt werden. Zur Herstellung freier Carbene kann auch flüssiger Ammoniak, gegebenenfalls im Gemisch mit Tetrahydrofuran, als Lösungsmittel eingesetzt werden.

Ein Verfahren zur Herstellung der Übergangsmetallkomplexe der allgemeinen Formel IC umfasst somit Deprotonierung von den den entsprechenden Carbenliganden entsprechenden Ligandvorläufern und anschließende Umsetzung mit geeigneten, das gewünschte Metall enthaltenden, Metallkomplexen.

Die Deprotonierung der Ligandvorläufer kann durch basische Metallate, basische Anionen wie Metallacetate, Acetylacetonate oder Alkoxylate oder externe Basen wie $KO^tBu$, $NaO^tBu$, $LiO^tBu$, NaH, Silylamide, Amide sowie Phosphazenbasen erfolgen.

Bevorzugt werden die Übergangsmetallkomplexe der Formel IC mit N-heterocyclischen Carbenliganden durch Deprotonierung der entsprechenden kationischen Vorstufen ausgewählt aus der Gruppe bestehend aus Azoliumsalzen, insbesondere Imidazoliumsalzen, Benzimidazoliumsalzen; Triazoliumsalzen und Azolidiniumsalzen, insbesondere Imidazolidiniumsalzen, mit einer externen Base, bevorzugt $KO^tBu$ oder Silylamide, besonders bevorzugt Silylamide, z. B. Kalium-bis-(trimethylsilyl)amid, umgesetzt. Das erhaltene Zwischenprodukt wird anschließend mit einem Komplex des gewünschten Metalls umgesetzt.

Geeignete Komplexe des gewünschten Metalls sind dem Fachmann bekannt. Das gewünschte Metall in dem eingesetzten Metallkomplex und das entsprechende Metall des daraus hergestellten Übergangsmetallkomplexes IC müssen nicht dieselbe Oxidationsstufe aufweisen.

Bei der Herstellung von Iridium(III)-Komplexen der allgemeinen Formel IC, die gemäß der vorliegenden Erfindung besonders bevorzugt sind, können beispielsweise die folgenden Iridium(III)-Komplexe eingesetzt werden: $[(\mu\text{-Cl})Ir(\eta^4\text{-1,5-cod})]_2$, $[(\mu\text{-Cl})Ir(\eta^2\text{-1,5-coe})_2]_2$, $Ir(acac)_3$, $IrCl_3 \times n\, H_2O$, $(tht)_3IrCl_3$, worin cod Cyclooctadien, coe Cycloocten, acac Acetylacetonat und tht Tetrahydrothiophen bedeuten.

Die Umsetzung erfolgt bevorzugt in einem Lösungsmittel. Geeignete Lösungsmittel sind bevorzugt ausgewählt aus der Gruppe bestehend aus aromatischen, aliphatischen Lösungsmitteln, Ethern, Alkoholen und halogenierten Kohlenwasserstoffen. Alkohole und halogenierte Kohlenwasserstoffe werden im Allgemeinen nur dann eingesetzt, wenn in der Umsetzung kein freies Carben gebildet wird. Zur Generierung von freien Carbenen kann des Weiteren flüssiger Ammoniak als Lösungsmittel eingesetzt werden.

Alkoxid-Derivate oder Wanzlick-Olefine werden üblicherweise bei Raumtemperatur zu den entsprechenden Metallvorstufen gegeben und anschließend thermisch belastet, wobei im Fall der Alkoxid-Derivate der entsprechende Alkohol abgespalten wird, bzw. die dimeren Wanzlick-Olefine gespalten werden und die Metall-Carben-Verbindung gebildet wird. Üblicherweise sind für diese Reaktion somit Temperaturen von 20 bis 120°C, bevorzugt 25 bis 110°C geeignet. Werden als Zwischenprodukte freie Carbene eingesetzt (z.B. Imidazolin-2-ylidene), so werden diese vorzugsweise zunächst unter Kühlung zur Metallvorstufe gegeben, anschließend erfolgt Erwärmung auf Raumtemperatur (20 bis 25°C) und gegebenenfalls anschließend weitere Erwärmung. Somit sind für diese Umsetzung Temperaturen von -78 bis +120°C geeignet.

Das Verhältnis von eingesetztem Metallkomplex zu eingesetztem Ligandvorläufer ist abhängig von dem gewünschten Komplex, der mindestens zwei Carbenliganden trägt. Handelt es sich bei dem Metallatom um Ir(III), was besonders bevorzugt ist, und enthält der gewünschte Übergangsmetallkomplex drei Carbenliganden, was ebenfalls besonders bevorzugt ist, so muss die molare Menge an Ligandvorläufern etwa dreimal so groß sein wie die molare Menge an Metall im Metallkomplex, wobei ein geringer Überschuss des Ligandvorläufers eingesetzt werden kann. Das molare Verhältnis von Metall im Metallkomplex zur molaren Menge an Ligandvorläufern beträgt somit bevorzugt 1 : 3 bis 1 : 5, besonders bevorzugt 1 : 3 bis 1 : 4.

Die molare Menge der eingesetzten Base ist abhängig von der molaren Menge des eingesetzten Ligandvorläufers, wobei die Base und der Ligandvorläufer in einem molaren Verhältnis von 2 : 1 bis 1 : 1, bevorzugt 1,5 : 1 bis 1,2 : 1 eingesetzt werden.

Im Folgenden ist beispielhaft die Herstellung von zwei Iridiumkomplexen mit N-heterocyclischen Carbenliganden dargestellt:

*Imidazolin- Yliden-Komplex.*

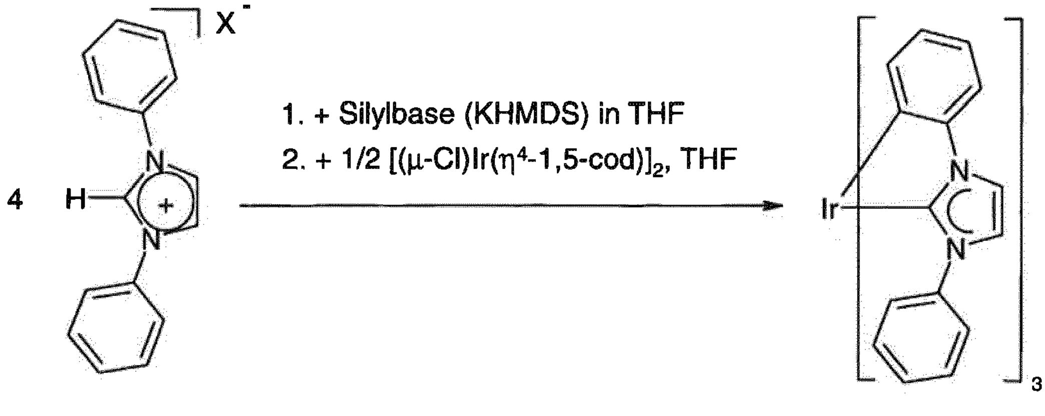


X' bedeutet eine anionische Gruppe, bevorzugt ein Halogenid, Pseudohalogenid oder eine andere monoanionische Gruppe, zum Beispiel $Cl^-$, $Br^-$, $BF_4^-$, $PF_6^-$, $CN^-$, $SCN^-$, besonders bevorzugt $BF_4^-$, $PF_6^-$.

*Benzimidazolin- Yliden-Komplex.*

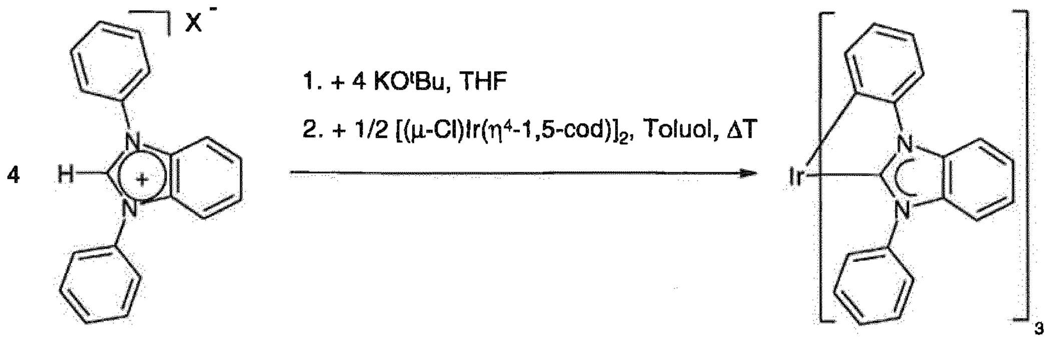


X⁻ wurde bereits vorstehend definiert.

Die erfindungsgemäß verwendeten Übergangsmetallcarbenkomplexe eignen sich hervorragend als Emittersubstanzen, da sie eine Emission (Elektrolumineszenz) im sichtbaren Bereich des elektromagnetischen Spektrums aufweisen. Mit Hilfe der erfindungsgemäß verwendeten Übergangsmetallcarbenkomplexe als Emittersubstanzen ist es möglich, Verbindungen bereit zu stellen, die Elektrolumineszenz im roten, grünen sowie im blauen Bereich des elektromagnetischen Spektrums aufweisen. Somit ist es möglich mit Hilfe der erfindungsgemäß verwendeten Übergangsmetallcarbenkomplexe als Emittersubstanzen technisch einsetzbare Vollfarbendisplays bereit zu stellen.

Durch die Zugänglichkeit von verschieden substituierten Carbenliganden sowie verschiedenen Übergangsmetallen lassen sich Emittersubstanzen herstellen, die in verschiedenen Bereichen des elektromagnetischen Spektrums Licht emittieren. Dabei ist die Quantenausbeute hoch und die Stabilität der Übergangsmetallcarbenkomplexe im Device, insbesondere solcher mit N-heterocyclischen Carbenliganden, hoch.

Des Weiteren sind die vorstehend genannten neutralen Übergangsmetallkomplexe als Elektronen-, Excitonen- oder Lochblocker in OLEDs geeignet, in Abhängigkeit von den eingesetzten Liganden und dem eingesetzten Zentralmetall.

Organische Licht-emittierende Dioden sind grundsätzlich aus mehreren Schichten aufgebaut. (siehe Figur 1)

1. Anode
2. Löcher-transportierende Schicht
3. Licht-emittierende Schicht
4. Elektronen-transportierende Schicht
5. Kathode

Es ist jedoch auch möglich, dass das OLED nicht alle der genannten Schichten aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Die Übergangsmetallcarbenkomplexe können in verschiedenenen Schichten eines OLEDs eingesetzt werden. Ein Gegenstand der vorliegenden Erfindung ist daher ein OLED enthaltend mindestens einen Übergangsmetallcarbenkomplex gemäß der vorliegenden Beschreibung. Die Übergangsmetallcarbenkomplexe werden bevorzugt in der Licht-emittierenden Schicht als Emittermoleküle eingesetzt.

Bevorzugte Übergangsmetallcarbenkomplexe, insbesondere Übergangsmetallcarbenkomplexe mit N-heterocyclischen Carbenliganden, sind bereits vorstehend genannt.

Die erfindungsgemäß verwendeten Übergangsmetallcarbenkomplexe können in Substanz - ohne weitere Zusätze - in der Licht-emittierenden Schicht oder einer anderen Schicht des OLEDs, bevorzugt in der Licht-emittierenden Schicht, vorliegen. Es ist jedoch ebenfalls möglich, dass neben den erfindungsgemäß eingesetzten Übergangsmetallcarbenkomplexen weitere Verbindungen in den Schichten enthaltend mindestens einen Übergangsmetallcarbenkomplex , bevorzugt in der Licht-emittierenden Schicht, vorliegen. Beispielsweise kann in der Licht-emittierenden Schicht ein fluoreszierender Farbstoff anwesend sein, um die Emissionsfarbe des als Emittermoleküls eingesetzten Übergangsmetallcarbenkomplexes zu verändern. Des Weiteren kann ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N, N'-Dicarbazolbiphenyl (CDP=CBP) oder tertiäre aromatische Amine. Wenn ein Verdünnungsmaterial eingesetzt wird, beträgt der Anteil der erfindungsgemäß eingesetzten Übergangsmetallcarbenkomplexe in der Licht-emittierenden Schicht im Allgemeinen weniger als 30 Gew.-%, bevorzugt weniger als 20 Gew.-%, besonders bevorzugt 3 bis 10 Gew.-%.

Die einzelnen der vorstehend genannten Schichten des OLEDs können wiederum aus 2 oder mehreren Schichten aufgebaut sein. Beispielsweise kann die Löcher-transportierende Schicht aus einer Schicht aufgebaut sein, in die aus der Elektrode Löcher injiziert werden und einer Schicht, die die Löcher von der Lochinjektionsschicht weg in die Licht-emittierende Schicht transportiert. Die Elektronen-transportierende Schicht kann ebenfalls aus mehreren Schichten bestehen, zum Beispiel einer Schicht, worin Elektronen durch die Elektrode injiziert werden, und einer Schicht, die aus der Elektroneninjektionsschicht Elektronen erhält und in die Licht-emittierende Schicht transportiert. Diese genannten Schichten werden jeweils nach Faktoren wie Energieniveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß als Emittersubstanzen verwendeten Übergangsmetallcarbenkomplexe angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegenden Anmeldung ist ein OLED enthaltend mindestens eine Licht-emittierende Schicht umfassend einen wie oben beschriebenen Übergangsmetallcarbenkomplex. Die weiteren Schichten in dem OLED können aus einem beliebigen Material aufgebaut sein, das üblicherweise in solchen Schichten eingesetzt wird und dem Fachmann bekannt ist.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO).

Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in Kirk-Othmer, Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (α-NPD), N, N'-Diphenyl-N, N'-Bis(3-methylphenyl)-[1,1'-biphenyl]-4,4'-diamin (TPD), 1,1-Bis[(di-4-tolylamino)-phenyl]cyclohexan (TAPC), N, N'-Bis(4-methylphenyl)-N, N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB) 4,4',4"-tris(N,N-Diphenylamino)triphenylamin (TDTA) und Porphyrinverbindungen sowie Phthalocyaninen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen, PEDOT (Poly(3,4-ethylendioxythiophen), bevorzugt PEDOT dotiert mit PSS (Polystyrolsulfonat), und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronentransportmaterialien für die Schicht (4) der erfindungsgemäßen OLEDs umfassen mit oxinoiden Verbindungen chelatisierte Metalle wie Tris(8-hydroxychinolato)aluminium ($Alq_3$), Verbindungen auf Phenanthrolinbasis wie 2,9-Dimethyl, 4,7-Diphenyl-1, 10-phenanthrolin (DDPA = BCP) oder 4,7-Diphenyl-1, 10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Excitons an den Grenzflächen der Schichten des OLEDs zu vermeiden. Vorzugsweise verbessert die Schicht (4) die Beweglichkeit der Elektronen und reduziert ein Quenchen des Excitons.

Von den vorstehend als Lochtransportmaterialien und Elektronen transportierende Materialien genannten Materialien können einige mehrere Funktionen erfüllen. Zum Beispiel sind einige der Elektronen leitenden Materialien gleichzeitig Löcher blockende Materialien, wenn sie ein tief liegendes HOMO aufweisen.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Beispielsweise können die Lochtransportmaterialien mit Elektronenakzeptoren dotiert werden, zum Beispiel können Phthalocyanine bzw. Arylamine wie TPD oder TDTA mit Tetrafluorotetracyano-chinodimethan (F4-TCNQ) dotiert werden. Die Elektronentransportmaterialien können zum Beispiel mit Alkalimetallen dotiert werden, beispielsweise $Alq_3$ mit Lithium. Die elektronische Dotierung ist dem Fachmann bekannt und zum Beipsiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo, Appl. Phys. Lett., Vol. 82, No. 25, 23 June 2003 und Pfeiffer et al., Organic Electronics 2003, 4, 89 - 103 offenbart.

Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe 1, zum Beispiel Li, Cs, Erdalkalimetallen der Gruppe 2, Metallen der Gruppe 12 des Periodensystems der Elemente, umfassend die Seltenerdmetalle und die Lanthanide und Aktinide. Des Weiteren können Metalle wie Aluminium, Indium, Calcium, Barium, Samarium und Magnesium sowie Kombinationen davon eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Das OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das erfindungsgemäße OLED zusätzlich zu den Schichten (1) bis (5) mindestens eine der im Folgenden genannten weiteren Schichten:

- eine Loch-Injektionsschicht zwischen der Anode (1) und der Löchertransportierenden Schicht (2);
- eine Blockschicht für Elektronen und/oder Excitonen zwischen der Löchertransportierenden Schicht (2) und der Licht-emittierenden Schicht (3);
- eine Blockschicht für Löcher und/oder Excitonen zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Es ist jedoch auch möglich, dass das OLED nicht alle der genannten Schichten (1) bis (5) aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Dem Fachmann ist bekannt, wie er (zum Beispiel auf Basis von elektrochemischen Untersuchungen) geeignete Materialien auswählen muss. Geeignete Materialien für die einzelnen Schichten sind dem Fachmann bekannt und z.B. in WO 00/70655 offenbart.

Des Weiteren kann jede der genannten Schichten des erfindungsgemäßen OLEDs aus zwei oder mehreren Schichten aufgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz zu erhalten.

Die Herstellung des erfindungsgemäßen OLEDs kann nach dem Fachmann bekannten Methoden erfolgen. Im Allgemeinen wird das OLED durch aufeinanderfolgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden. Zusammensetzungen, die neben dem mindestens einen Übergangsmetallcarbenkomplex ein polymeres Material in einer der Schichten des OLEDs, bevorzugt in der Licht-emittierenden Schicht, aufweisen, werden im Allgemeinen mittels lösungsverarbeitenden Verfahren als Schicht aufgebracht.

Im Allgemeinen haben die verschiedenen Schichten folgende Dicken: Anode (2) 500 bis 5000 Ä, bevorzugt 1000 bis 2000 Å; Löcher-transportierende Schicht (3) 50 bis 1000 Ä, bevorzugt 200 bis 800 Ä, Licht-emittierende Schicht (4) 10 bis 1000 Ä, bevorzugt 100 bis 800 Ä, Elektronen transportierende Schicht (5) 50 bis 1000 Å, bevorzugt 200 bis 800 Ä, Kathode (7) 200 bis 10.000 Ä, bevorzugt 300 bis 5000 Å. Die Lage der Rekombinationszone von Löchern und Elektronen in dem erfindungsgemäßen OLED und somit das Emissionsspektrum des OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz des erfindungsgemäß verwendeten Übergangsmetallcarbenkomplexe in mindestens einer Schicht des erfindungsgemäßen OLEDs, bevorzugt als Emittermolekül in der Licht-emittierenden Schicht der erfindungsgemäßen OLEDs, können OLEDs mit hoher Effizienz erhalten werden. Die Effizienz der erfindungsgemäßen OLEDs kann des Weiteren durch Optimierung der anderen Schichten verbessert werden. Beispielsweise können hoch effiziente Kathoden wie Ca, Ba oder LiF eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z.B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Digitalkameras, Fahrzeugen sowie Zielanzeigen an Bussen und Bahnen.

Weiterhin können die erfindungsgemäß eingesetzten Übergangsmetallcarbenkomplexe in OLEDs mit inverser Struktur eingesetzt werden. Bevorzugt werden die Übergangsmetallcarbenkomplexe in diesen inversen OLEDs wiederum in der Licht-emittierenden Schicht eingesetzt. Der Aufbau von inversen OLEDs und die üblicherweise darin eingesetzten Materialien sind dem Fachmann bekannt.

Die nachfolgenden Beispiele erläutern die Erfindung zusätzlich.

**Beispiele**

**1. Herstellung der Liganden:**

Die notwendigen Ligandvorstufen wurden in Anlehnung an Literaturvorschriften hergestellt:

**a) Verbindung (1)**

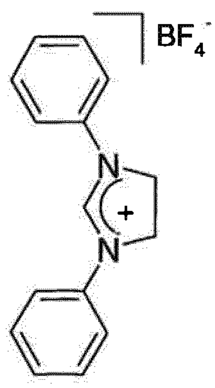

(1)

Die Synthese erfolgt ausgehend von N,N-Diphenylethan-1,2-diamin in Anlehnung an Organic Letters, 1999, 1, 953-956; Angewandte Chemie, 2000, 112, 1672-1674. Das Bisamin wird dabei mit Triethlyformiat in Gegenwart von Ammoniumtetrafluoroborat umgesetzt.

Nach Rekristallisation in Ethanol wurde die Verbindung erhalten.

$^1$H-NMR (400 MHz, DMSO):
$\delta$ = 4.60 (s, 4H, $CH_2$), 7.40 (tt, 2H), 7.57 (dd, 4H), 7.65 (dd, 4H), 9.95 (s, 1H, $C^+H$)

$^{13}$C-NMR (100 MHz, DMSO):
$\delta$ = 48.2, 118.4, 127.0, 129.6, 136.0, 151.7

**b) Verbindung (2)**

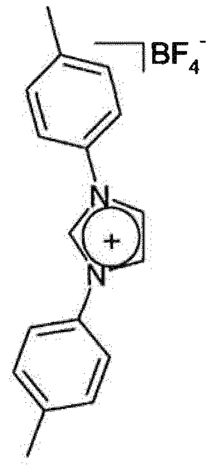

(2)

Die Synthese startet in Anlehnung an Chem. Ber. 1971, 104, 92-109 (besonders Seite 106) mit der Herstellung des Bisimins aus Glyoxal und Anilin, bzw. para-Toluidin.

Die erhaltenen Schiffsche Basen werden gemäß Journal of Organometallic Chemistry 2002, 606, 49-54 durch Behandlung mit einer salzsauren Suspension von paraFormaldehyd in Dioxan in das entsprechende Imidazoliumchlorosalz überführt.

Mit Anilin:

$\delta$ = 7.64 (t,2H), 7.72 (t, 4H), 7.93 (d, 4H), 8.60 (d, 2H), 10.75 (s, 1H)

MS (ESI, ACN/$H_2O$ 8/2):
m/e = 221.0

Mit para-Toluidin:

$^1$H-NMR (500 MHz, DMSO):
$\delta$ = 2.42 (s, 6H), 7.49 (d, 4H), 7.88 (d, 4H), 8.61 (d, 2H,), 10.52 (t, 1H)

Ein Austausch des Anions ist möglich durch Behandlung entweder mit $AgBF_4$ bzw. $NaBF_4$.

**c) Verbindung (3)**

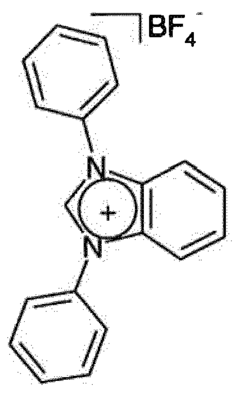

(3)

Die Synthese erfolgt ausgehend von 1,2-Phenylendiamin. Nach Einführung der Acetylgruppen auf die Aminofunktionen wurde das erhaltene Amid gemäss der Vorschrift aus Synthetic Communications, 2000, 30, 3651-3668 mit Hilfe eines Kupferkatalysierten Protokolls die Phenylgruppierung eingeführt. Ohne Aufreinigung wurde das Material in kochender ethanolischer KOH-Lösung behandelt. Das Produkt wurde durch Chromatographie erhalten.

$^1$H-NMR ($CD_2Cl_2$, 500 MHz):
$\delta$ = 5.70 (s, breit, 2H), 6.87 (t, 2H), 6.93 (d, 4H), 6.97 (dd, 2H), 7.22 (t, 4H), 7.28 (dd, 2H)

Die Herstellung des benötigten Imidazoliumsalzes erfolgte durch Behandlung von N,N'-Diphenylbenzol-1,2-diamin durch Triethylameisensäureorthoester in Gegenwart von Ammoniumtetrafluoroborat. Durch Kristallisation wurde das Material erhalten.

$^1$H-NMR (DMSO, 400 MHz):
δ = 7.74-7.84 (m, 8H), 7.91-7.98 (m, 6H), 10.57 (s, 1H)

**d) Verbindung (4)**

**da) Herstellung von Verbindung 4a**

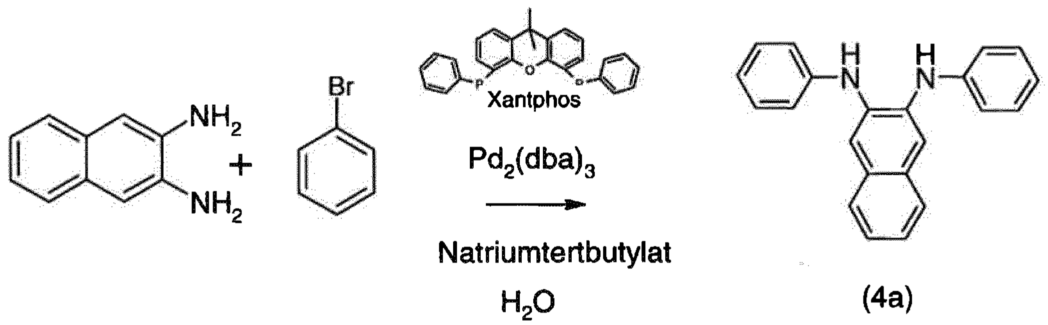


(4a)

In einem mit Argon gespülten Kolben legte man im Argon-Gegenstrom 3,16 g (20 mmol) des 2,3-Diaminonaphthalen (Acros) und 6,28 g (40 mmol) destilliertes Brombenzol (Aldrich) in 80 mL Toluol (wasserfrei) vor. Durch anlegen eines Vakuums an den Kolben entgaste man die braune Suspension. Danach belüftete man sie wieder mit Argon und gab im Argongegenstrom eine Spatelspitze $Pd_2(dba)_3$, eine Spatelspitze 9,9-Dimethyl-4,5-bis(diphenylphosphino)xanthene (Xantphos), 2,70 g (28 mmol) Natriumtertbutylat und 0,36 g (20 mmol) entgastes Wasser zu. Die braune Suspension wurde bis zum Rückfluss erhitzt und 15 h bei Rückfluss rühren gelassen. Danach wurde sie auf Raumtemperatur kommen gelassen.

Zur Aufarbeitung wurde der Ansatz mit Methylenchlorid verdünnt und zweimal gegen Wasser extrahiert, dann mit Natriumsulfat getrocknet und nach Filtration das Filtrat im Vakuum eingeengt. Der Rückstand wurde säulenchromatographisch aufgereinigt (Kieselgel, Methylenchlorid mit 5 mL Triethylamin pro L Methylenchlorid). Die Fraktionen, die das Produkt enthielten, wurden vereinigt, und im Vakuum vom Lösungsmittel befreit. Es wurden 2,7 g (43,5%) von Verbindung (4a) erhalten.

$^1$H-NMR ($CDCl_3$, 400 MHz):
δ = 5.85 (s, breit, NH), 6.97 (tt, 2H, J = 7.3 Hz, J = 1.2 Hz), 7.07 (dd, 4H, J = 8.7 Hz, J = 1.1 Hz), 7.28-7.32 (m, 6H), 7.60 (dd, 2H, J = 6.1 Hz, J = 3.1 Hz), 7.64 (s, 2H)

MS (EI):
m/e = 310.0, 311.0, 312.0 ($M^+$)

**db) Herstellung von Verbindung (4)**

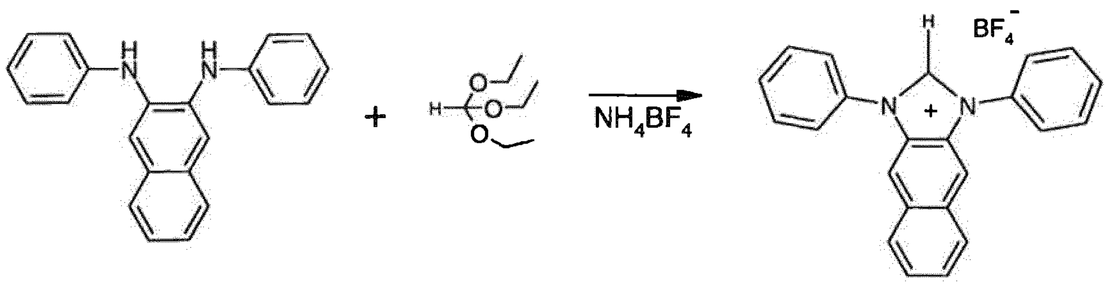


(4)

Einen Zweihalskolben spülte man 20 Minuten mit Stickstoff. Dann löste man 7,68 g (24,74 mmol) der 2,3-Di-N-phenylaminonaphthalin in 51,34 g (346,4 mmol) Triethylformiat bei 100°C und gab 2,59 g (24,74 mmol) Ammoniumtetrafluorborat auch unter Stickstoff Gegenstrom hinzu. Dann heizte man die Lösung bis zum Rückfluss und ließ 12 h unter Rückfluss rühren. Darauf wurde das Reaktionsgemisch auf Raumtemperatur gebracht.

Zur Aufarbeitung wurde das Reaktionsgemisch über eine G4-Fritte abgesaugt und mit Orthoester gewaschen. Dann trochnete man ihn bei 50°C im Vakuumtrockenschrank. Das so erhaltene Material (6.05 g) wurde in Methylenchlorid gelöst und über einen Filter abgesaugt. Die Mutterlauge engte man im Vakuum ein und trocknete sie bei 50°C erneut im Vakkumtrockenschrank. Es wurden 5,37 g (53%) der Verbindung (4) erhalten.

$^1$H-NMR (0114600902, 400 MHz, $CD_2Cl_2$):

$\delta$ = 7.69 (dd, 2H, J 2.9 Hz, J = 6.7 Hz), 7.76-7.82 (m, 6H), 7.91-7.95 (m, 4H), 8.10 (dd, 2H, J = 3.3 Hz, J = 6.6 Hz), 8.29 (s, etwas breiter, 2H), 9.75 (s, 1H)

Elementaranalytik:

| | | | | |
|---|---|---|---|---|
| Exp. | 18,3 % F | 67,2 % C | 6,8 % N | 4,10 % H |
| Theor. | 18.6 % F | 67.6 % C | 6.8 % N | 4,16 % H |

**2. Herstellung der Metallkomplexe:**

Ir(Imidazolidin)$_3$ wurde in Anlehnung an eine Vorschrift von P. B. Hitchcock, M. F. Lappert, P. Terreros, J. Organomet. Chem. 1982, 239, C26-C30 hergestellt. Im Gegensatz zur erwähnten Literaturvorschrift wurde als Edukt das Imidazolidiniumsalz und nicht das Wanzlick-Olefin eingesetzt.

Darstellung der Metallcarbenkomplexe (Alle beschriebenen Synthesen wurden unter Inertgasatmosphäre mittels Schlenk-Technik in absoluten Lösungsmitteln durchgeführt):

**a) Herstellung eines Ir-Komplexes (5)**

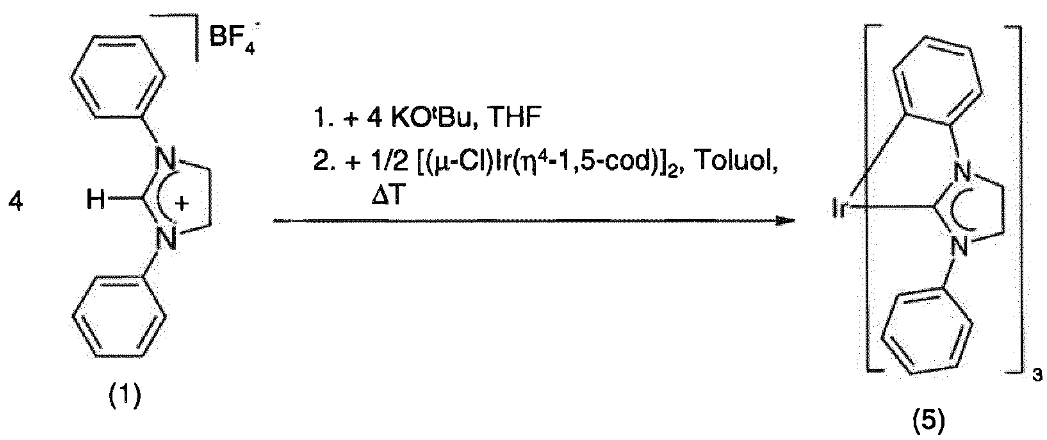


(1)

(5)

In einem 100 mL Dreihalskolben wurden 3.0 g (9.6 mmol) des Imidazoliumsalzes (Verbindung (1)) in 40 mL Tetrahydrofuran suspendiert. Die hellbraune Suspension wurde bei Raumtemperatur mit einer Lösung von 1.11 g (9.7mmol) $KO^tBu$ in 10 mL THF versetzt. Der Ansatz wurde eine Stunde bei Raumtemperatur gerührt und anschließend zur Trockene eingeengt. Nach Wiederaufnahme in 30 mL Toluol wurde diese Suspension zu einer Lösung von 820 mg (1.2 mmol) $[(\mu\text{-Cl})(\eta^4\text{-1,5-cod})Ir]_2$ in 20 mL Toluol zugegeben. Die Reaktionsmischung wurde 2 Stunden unter Rückfluß erhitzt, über Nacht bei Raumtemperatur gerührt und im Anschluß nochmals 3.5 Stunden unter Rückfluß erhitzt. Man ließ auf Raumtempertur abkühlen. Der Niederschlag wurde abfiltriert, mit Toluol gewaschen, mit Methylenchlorid extrahiert und das Methylenchlorid im Vakuum entfernt. Der Rückstand wurde einer säulen-chromatographischen Reinigung unterzogen. Es resultierte ein hellgelbes Pulver (240 mg, 15 %).

$^{13}$C-NMR ($CD_2Cl_2$, 125 MHz): 200.0 (NCN), 149.3, 146.5, 142.5 (je $C_q$ bzw. $IrC_{Phenyl}$), 134.5, 127.2, 126.5, 125.5, 120.6, 119.7, 106.8 (je $CH_{Phenyl}$), 53.8, 44.1 ($NCH_2CH_2N$).

Masse (EI): m/e = 856.

Optische Spektroskopie: $\lambda$ = 533 nm (Hauptmaximum des Pulvers).

**b) Herstellung eines Ir-Komplexes (6)**

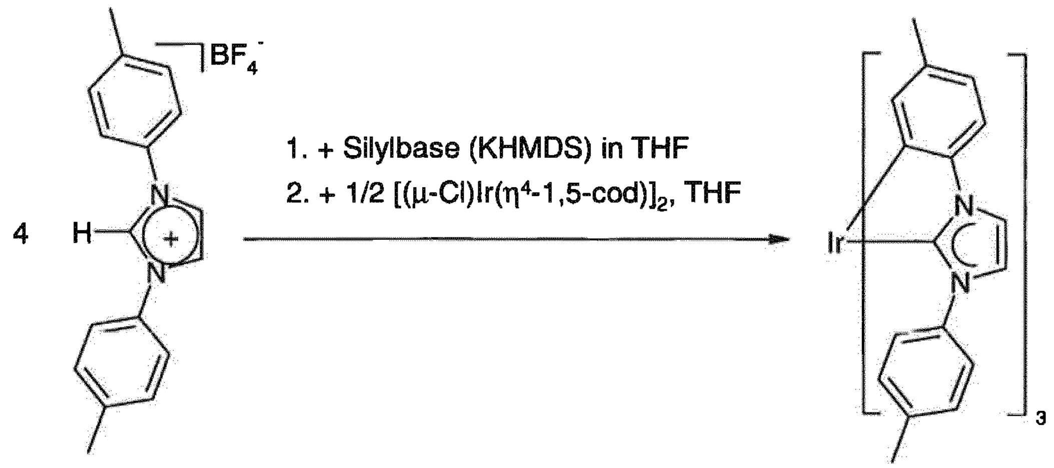


(2) (6)

In einem 100 mL Dreihalskolben wurden 0.92 g (2.7 mmol) des Imidazoliumsalzes (Verbindung (2)) in 20 mL Tetrahydrofuran gelöst. Bei -8 °C wurden innerhalb von 10 Minuten 547 mL Base (0.5 M in Toluol, 2.8 mmol) zugesetzt und der Ansatz 1 Stunde bei Raumtemperatur gerührt.

310 mg (0.460 mmol) $[(\mu\text{-Cl})(\eta^4\text{-1,5-cod})Ir]_2$ wurden in 20 mL THF gelöst, auf -78 °C abgekühlt und hierzu tropfenweise die Salzmischung zugegeben. Der Ansatz wurde 2 h bei 60 °C, über Nacht bei Raumtemperatur, 8h unter Rückfluß und anschließend über Nacht bei Raumtemperatur gerührt. Nach Filtration wurde bis zur Trockne eingeengt und der braune Rückstand einer säulenchromatographischen Reinigung unterzogen. Es wurde ein weißes Pulver erhalten (170 mg, 20 %)

$^{1}$H-NMR ($CD_2Cl_2$, 500 MHz): 7.23 (1H, $CH_{Phenyl}$ bzw. NCHCHN), 7.02 (1H), 6.79 (2H), 6.68 (1H), 6.30 (2H), 5.85 (2H) (je $CH_{Phenyl}$ bzw. NCHCHN), 2.21 (3H, $CH_3$), 2.01 (3H, $CH_3$).

$^{13}$C-NMR ($CD_2Cl_2$, 125 MHz): 174.8 (NCN), 149.3, 144.2, 137.6, 135.7, 132.3 (je $C_q$ bzw. $IrC_{Phenyl}$), 139.6, 127.8, 125.0, 120.2, 120.0, 113.4, 109.1 ($CH_{Phenyl}$ bzw. NCHCHN), 20.5, 19.9 (je $CH_3$).

Masse (EI): m/e = 934.

Optische Spektroskopie: $\lambda$ = 489 nm (Hauptmaximum des Pulvers).

**c) Herstellung eines Ir-Komplexes (7)**

**Synthesevariante I**

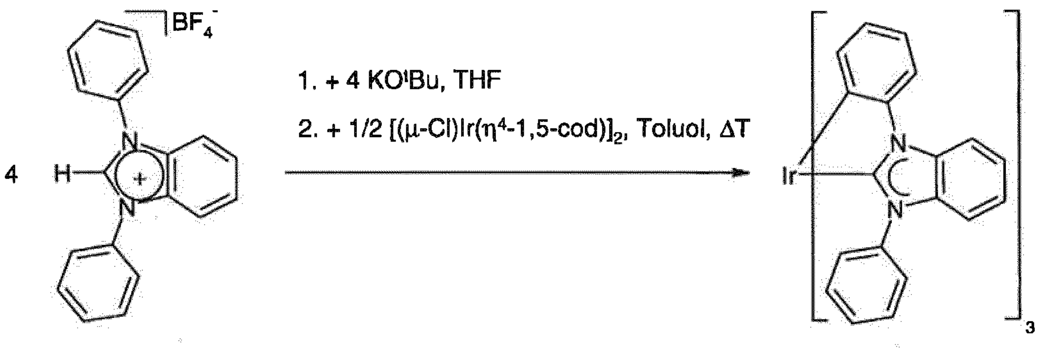


(3) (7)

In einem 100 mL Dreihalskolben wurden 0.99 g (2.8 mmol) des Benzimidazoliumsalzes (Verbindung (3)) in 20 mL THF suspendiert. Zu dieser hellgelben Suspension wurde eine Lösung von 0.32 g KO$^t$Bu in 10 mL THF bei Raumtemperatur zugegeben. Der Ansatz wurde 45 min bei Raumtemperatur gerührt und anschließend zur Trockene eingeengt. Nach Wiederaufnahme in 25 mL Toluol wurde diese Suspension zu einer Lösung von 310 mg [(μ-Cl)(η$^4$-1,5-cod)Ir]$_2$ (0.46 mmol) in 30 mL Toluol gegeben. Anschließend wurde der Ansatz 15 Minuten bei Raumtemperatur, über Nacht bei 80 °C, 8 Stunden unter Rückfluß, übers Wochenende bei Raumtemperatur und 5 Stunden unter Rückfluß erhitzt. Nach dem Abkühlen wurde der Niederschlag abgetrennt und das Filtrat eingeengt. Das erhaltene gelbe Pulver wurde einer säulenchromatographischen Reinigung unterzogen. Es wurde ein weißes Pulver erhalten (410 mg, 43 %)

**Synthesevariante II**

In einem 100 mL Dreihalskolben wurden 1.32 g (3.7 mmol) des Benzmidazoliumsalzes (Verbindung (3)) in 25 mL Toluol vorgelegt. Bei Raumtemperatur wurden innerhalb von 30 Minuten 7.5 mL Kalium-bistrimethylsilylamid (0,5 M in Toluol, 3.7 mmol) zugesetzt und der Ansatz 30 Minuten bei Raumtemperatur gerührt. 310 mg (0.46 mmol) [(μ-Cl)(η$^4$-1,5-cod)Ir]$_2$ wurden in 30 mL Toluol gelöst und bei Raumtemperatur tropfenweise mit der Salzmischung versetzt. Der Ansatz wurde eine Stunde bei Raumtemperatur gerührt, dann zwei Stunden bei 70 °C und im Anschluss über Nacht unter Rückfluss. Nach Filtration wurde bis zur Trockne eingeengt und der braune Rückstand einer säulenchromatographischen Reinigung unterzogen. Es wurde ein weißes Pulver erhalten (0.75 g, 82 %)

Der Ir-Komplex (7) wird als Gemisch aus dem kinetisch bevorzugten meridionalen (mer)-Isomeren und dem thermodynamisch bevorzugten facialen (fac)-Isomeren gebildet.

$^1$H-NMR (fac/mer-Isomerengemisch, Daten des Hauptisomers (fac-Isomer), $CDCl_3$, 500 MHz): 8.03 (d, 1H), 7.85 (d, 1H), 7.21 (m, 2H), 7.01 (m, 1H), 6.93 (m, 1H), 6.65 (m, 1H), 6.61 (m, 1H), 6.53 (m, 1H), 6.47 (m, 1H), 6.35 (d, 1H), 6.20 (m, 1H), 6.11 (m, 1H) je ($CH_{Aryl}$ bzw. NCHCHN).

$^{13}$C-NMR (fac/mer-Isomerengemisch, Daten des Hauptisomers (fac-Isomer), $CDCl_3$, MHz): 187.8 (NCN), 148.8, 147.8, 137.2, 136.9, 131.7 (je $C_q$ bzw. $IrC_{Phenyl}$), 135.9, 127.8, 127.3, 127.0, 126.6, 126.4, 123.6, 121.9, 120.8, 120.3, 111.6, 109.9, 109.5 ($CH_{Aryl}$).

Masse (fac/mer-Isomerengemisch, EI): m/e = 1000.0.

Elementaranalyse (fac/mer-Isomerengemisch, $IrC_{54}H_{39}N_6 \cdot 3/4CH_2Cl_2$): C 65.2 %, H 3.8 %, N 7.9 %, Cl 5.0; gef.: C 64.8 %, H 4.0 %, N 8.1 %, Cl 4.9 %.

Optische Spektroskopie: λ = 467 nm (fac/mer-Isomerengemisch, Hauptmaximum des Pulvers)

DTA (fac/mer-Isomerengemisch): Bei der Messung in Luft zeigt sich eine rasche Zersetzung bei ca. 350°C. Die Zersetzung der Probe in Inertgas beginnt ca. bei 380°C. (Messbedingungen: unter Luft: 28.0/5.0 (K/min)/750.0,

unter Inertgas: 30.0/5.00 (K/min)/710).

**d) Chromatographie, Auftrennung des *fac-* und *mer-* Isomeren des Ir-Komplexes der Formel (7)**

Im DC (Laufmittel Toluol) sind 2 Spots zu erkennen, wobei das fac-Isomer bei $R_F$ = 0.5 läuft und das mer-Isomer bei ca. $R_F$= 0.35.

0.46 g des zu trennenden Materials wurden in Toluol unter Zugabe von einer geringen Menge $CH_2Cl_2$ und unter Erwärmen auf ca. 30-40 °C gelöst.

Anschließend wurden die beiden Isomere über Kieselgel (0,063-0,200mm J.T. Baker) mit Toluol als Laufmittel chromatographisch unter kleiner Fraktionierung aufgetrennt (Dimensionierung der Säule: 30cm lang, Durchmesser: 6 cm).

Erhalten wurden *fac*-Iso*mer*: 0.2886g

$^1$H-NMR ($CD_2Cl_2$, 500 MHz) (*fac*):
$\delta$ = 8.10 (d, 3H), 7.94 (d, 3H), 7.28 (m, 6H), 7.06 (m, 3H), 7.02 (m, 3H), 6.74 (m, 3H), 6.68 (m, 3H), 6.60 (d, 3H), 6.56 (d, 3H), 6.42 (d, 3H), 6.29 (m, 3H), 6.18 (d, 3H).

mer-Isomer: 0,0364g

$^1$H-NMR ($CD_2Cl_2$, 500 MHz, -20 °C) (*mer*):
$\delta$ = 8.30 (d, 1H), 7.89 (m, 2H), 7.73 (d, 1H), 7.56 (d, 1H), 7.31 (d, 1H), 7.28-7.16 (m, 5H), 7.08-7.01 (m, 3H), 6.98 (m, 1H), 6.93 (m, 1H), 6.85-6.20 (m, 21H), 5.78 (d, 1H), 5.64 (d, 1H).

**e) Herstellung eines Ir-Komplexes (8)**

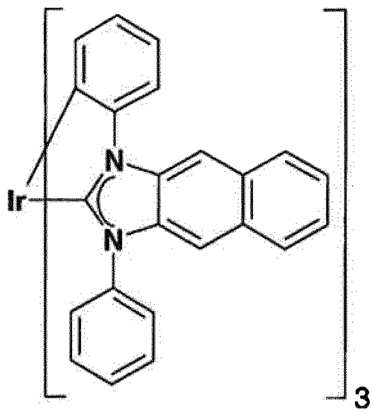

In einem 100 mL Dreihalskolben wurden 1.51 g (3.7 mmol) des Naphthimidazoliumsalzes in 40 mL Toluol vorgelegt. Bei RT °C wurden innerhalb von 30 Minuten 7.4 mL Kaliumbis(trimethylsilyl)amid (0,5 M in Toluol, 3.7 mmol) zugesetzt und der Ansatz 30 Minuten bei Raumtemperatur gerührt. 310 mg (0.46 mmol) $[(\mu\text{-Cl})(\eta^4\text{-1,5-cod})Ir]_2$ wurden in 30 mL Toluol gelöst und bei Raumtemperatur tropfenweise mit der Salzmischung versetzt. Der Ansatz wurde eine Stunde bei Raumtemperatur gerührt, dann zwei Stunden bei 70 °C und dann über Nacht unter Rückfluß. Der Ansatz wurde bis zur Trockne eingeengt und der braune Rückstand einer säulenchromatographischen Reinigung unterzogen. Es wurde ein hellgelbes Pulver erhalten (0.37 g, 35 %).

$^1$H-NMR (fac/mer-Isomerengemisch, Daten des Hauptisomers (fac-Isomer)): ($CD_2Cl_2$, 500 MHz): $\delta$ = 8.47 (s, 1H), 8.05 (m, 2H), 7.57 (d, 1H), 7.41 (m, 1H), 7.33 (d, 1H), 7.28 (t, 1H), 7.09 (m, 1H), 6.75 (s, 1H), 6.69 (d, 1H), 6.64 (t, 1H)6.57 (d, 1H), 6.52 (m, 1H), 6.24 (m, 2H).

$^{13}$C-NMR (fac/mer-Isomerengemisch, Daten des Hauptisomers (fac-Isomer)): ($CD_2Cl_2$, 125 MHz): $\delta$ = 193.9 (NCN), 146.67, 137.6, 136.9, 131.4, 129.5, 128.4 (C), 135.7, 128.2, 127.5, 127.4, 127.3, 127.0, 126.8, 126.7, 124.2, 124.0, 123.7, 120.7, 111.8, 106.2, 105.4 (CH).

Masse (EI): m/e = 1151 (M-H$^+$).

Elementaranalyse (fac/mer-Isomerengemisch, $IrC_{69}H_{45}N_6 \cdot 1/2CH_2Cl_2$): C 70.0 %, H 3.9 %, N 7.1 %; gef.: C 69.9 %, H 4.2 %, N 7.0 %,

DTA: Bei der Messung in Luft zeigt sich eine Zersetzung ab ca. 360°C. (Messbedingungen: 35.0/5.0 (K/min)/720.0).

**f) Kristallstrukturanalyse des fac-Isomeren des Ir-Komplexes (7)**

Zur Röntgenstrukturanalyse geeignete Kristalle wurden unter Inertgasatmosphäre durch Lösen langsames Eindiffundieren von Pentan in eine Lösung eines *fac*/*mer*-Isomerengemisches des Ir-Komplexes (7) in Methylenchlorid erhalten. In Fig. 2 ist die Kristallstruktur des fac-Isomeren des Ir-Komplexes (7) dargestellt. Die Längen der Ir-Carbenkohlenstoffbindungen der drei Liganden entsprechen mit 2.034 Å, 1.997 Å und 2.025 Å je einer Ir-C-Einfachbindung. Auffällig ist die Zusammenlagerung von jeweils zwei Molekülen des Ir-Komplexes (7) über jeweils einen der anellierten Phenylringe. Der durchschnittliche Abstand der beteiligten Phenylringebenen beträgt 3.6 Å.

**g) Optische Spektroskopie des Ir-Komplexes (7)**

**ga) Messung von optischen Eigenschaften in Abhängigkeit vom Isomerenverhältnis**

Proben des Ir-Komplexes (7) wurden in einer Konzentration von 2 mg/L in Toluol ("spectroscopic grade") vermessen. Dabei wurden verschiedene Proben mit unterschiedlichen fac-mer-Isomerenverhältnissen untersucht.

**gaa) Proben**

Folgende Proben mit unterschiedlichen Isomerenreinheiten wurden bezüglich ihrer optischen Eigenschaften charakterisiert (Tab. 1) und im Folgenden gegenübergestellt.

*Tab. 1: Zusammensetzung der Proben für die optische Spektroskopie*

| Probe # | | *fac*/*mer*-Verhältnis |
|---|---|---|
| 1 | Aus Beispiel 2c | 9:1[a] |
| 2 | sublimative Abtrennung des fac-Isomeren [c)] | 2:1[a] |
| 3 | durch Säulenchroma- | 29:1[b] |
| 4 | tographie (Beispiel 2d) | 1:37[b] |

a) Verhältnis laut $^1$H-NMR
b) Verhältnis laut HPLC
c) die Sublimation erfolgt in einer Hochvakuumanlage (Membranvorpumpe, Turbomolekularpumpe) bei p = 1 × $10^{-5}$ mbar. Die Substanzmenge wurde in ein Vorlagegefäß gefüllt, die Apparatur vorsichtig evakuiert und die Temperatur graduell erhöht. Die Sublimation wurde fraktioniert durchgeführt.

**gab) Absorptionsspektren des Ir-Komplexes (7) in Toluol**

Es wurden normierte Absorptionsspektren der Proben 1 bis 4 in Toluol ermittelt. Der Roh-Ir-Komplex (7) (Probe 1) und Probe 2 unterscheiden sich spektroskopisch in Toluollösung nicht. Das fac-Isomer (Probe 3) ist gegenüber dem *mer*-Isomer (Probe 4) um 6 nm hypsochrom verschoben und zeigt deutlich eine Schulter bei 335 nm. Eine rechnerische Überlagerung der *fac*- und *mer*-Spektren im Verhältnis von 80 / 20 liefert quasi-identisch das Absorptionspektrum der Ausgangsprobe (Probe 1). Dies bestätigt, dass die Ausgangsmischung beide Isomere in dem gewichteten Verhältnis $z_{fac}/z_{mer}$ von 80/20 enthält.

Ein normiertes Absorptionsspektrum entspricht der gemessenen optischen Dichte relativ zur optischen Dichte im Absorptionsmaximum, es ist konzentrationsunabhängig und beschreibt nur die Bandenform.

$$OD_i^{norm}(\lambda) = \frac{OD_i(\lambda)}{OD_i^{max}(\lambda_{max})} = \frac{\varepsilon_i(\lambda)}{\varepsilon_i^{max}}$$

Für die rechnerische Überlagerung gilt:

$$OD_{cal}^{norm}(\lambda) = \frac{OD_{fac}^{max}\,OD_{fac}^{norm}(\lambda) + OD_{mer}^{max}\,OD_{mer}^{norm}(\lambda)}{OD_{fac}^{max} + OD_{mer}^{max}} N_{norm}$$
$$= \left(z_{fac}\,OD_{fac}^{norm}(\lambda) + z_{mer}\,OD_{fac}^{norm}(\lambda)\right) N_{norm}$$

mit

$$z_{fac} + z_{mer} = 1 \quad \text{und} \quad z_{fac} = \frac{OD_{fac}^{max}}{OD_{fac}^{max} + OD_{mer}^{max}}$$

Die Werte $z_{fac}$ und $z_{mer}$ geben die nach der optischen Dichte im Absorptionsmaximum gewichteten Anteile wieder und hängen vom Produkt aus dem molaren Extinktionskoeffizienten im Maximum $\varepsilon_{max}$ und der Konzentration ab. Sie sind nicht identisch mit den Molenbrüchen. Diese können mit Hilfe der Extinktionskoeffizienten am Absorptionsmaximum $\varepsilon_{max}$ (*fac* und *mer*) aus $z_{fac}$ und $z_{mer}$ erhalten werden. Das Verhältnis $z_{fac}$ / $z_{mer}$ gibt das Verhältnis der optischen Dichten der Absorptionsmaxima wieder. $N_{mer}$ ist der Normierungsfaktor, der garantiert, dass das Summenspektrum auf eins normiert ist.

**gac) Emissionsspektren des Ir-Komplexes (7) in Toluol**

Es wurden normierte Emissionspektren der Proben 1 bis 4 in Toluol ermittelt. In den Emissionsspektren unterscheiden sich *fac*- und *mer*-Isomer deutlich in Form und Lage der Maxima. Das *mer*-Spektrum ist deutlich bathochrom verschoben (Emissionsmaxima 395 vs. 461 nm). Der Beitrag des *mer*-Isomers in der Mischung zeigt sich in der Schulter um 450 nm im Emissionspektrum. Die Emissionsbande des *fac*-Isomers ist deutlich schmaler. Auch hier liefert eine rechnerische Überlagerung der normierten Emissionsspektren der beiden Isomere im Verhältnis von 80 / 20 das Spektrum der Ausgangsprobe.

Für die rechnerische Überlagerung normierter Emissionsspektren gilt:

$$I_{norm}^{em}(\lambda) = \frac{OD_{fac}(\lambda_{exc})\,\Phi_{fac}\,I_{fac}^{norm}(\lambda) + OD_{mer}(\lambda_{exc})\,\Phi_{mer}\,I_{mer}^{norm}(\lambda)}{OD_{fac}(\lambda_{exc})\,\Phi_{fac} + OD_{mer}(\lambda_{exc})\,\Phi_{mer}} N_{norm}$$
$$= \left(y_{fac}(\lambda_{exc})\; I_{fac}^{norm}(\lambda) + y_{mer}(\lambda_{exc})\; I_{mer}^{norm}(\lambda)\right) N_{norm} \quad \text{mit}$$

$$y_{fac}(\lambda_{exc}) + y_{mer}(\lambda_{exc}) = 1 \quad \text{und} \quad y_{fac}(\lambda_{exc}) = \frac{OD_{fac}(\lambda_{exc})\,\Phi_{fac}}{OD_{fac}(\lambda_{exc})\,\Phi_{fac} + OD_{mer}(\lambda_{exc})\,\Phi_{mer}}$$

Die Werte $y_{fac}$ und $y_{mer}$ hängen von der Anregungswellenlänge ab und geben die nach Emissionsintensität (gleich Produkt aus Absorption auf der Anregungswellenlänge OD ($\lambda_{exc}$) und Quantenausbeute $\Phi$) gewichteten Anteile zur Gesamtemission an. Sie sind nicht identisch mit den Molenbrüchen. Diese können mit Hilfe der Extinktionskoeffizienten am Absorptionsmaximum $\varepsilon_{max}$ (*fac* und *mer*) und den Quantenausbeuten der beiden Isomere aus $y_{fac}$ und $y_{mar}$ erhalten werden. $N_{mer}$ ist der Normierungsfaktor, der garantiert, dass das Summenspektrum auf eins normiert ist.

Die gemessenen Photolumineszenzquantenausbeuten der vier Proben variieren in Toluol nicht, weder in luftgesättigter Lösung noch unter Stickstoff (Tab. 2).

*Tab. 2: Quantenausbeuten der Photolumineszenz des Ir-Komplexes (7) in Toluol.*

| | QY[1)] / % Toluol luftgesättigt Exc[2)] 325 nm | QY[1)] / % Toluol stickstoffgesättigt Exc[2)] 325 nm |
|---|---|---|
| Probe 1 | 0,6 | 1,3 |
| Probe 2 | 0,6 | 1,4 |
| Probe 3 (fac) | 0,6 | 1,3 |
| Probe 4 (mer) | nicht bestimmt | 1,4 |

1) QY = Quantenausbeute
2) Exc = Anregungswellenlänge

Gegenüber Messungen in fester Matrix (zum Beispiel PMMA oder Diphenyl-di-o-tolylsilan (UGH 1)) zeigt der Emitter in stickstoffgesättigter Lösung eine um eine Größenordnung kleinere Lumineszenzquantenausbeute. Dieser Einfluss der Stoßlöschung durch Lösungsmittelmoleküle spiegelt sich auch in den Lumineszenzabklingzeiten des Ir-Komplexes (7) wieder: in Toluol, stickstoffgesättigt: 26,5 ns bzw. 25,8 ns vs. 10 % des Komplexes (7) in UGH1: 234 ns. Auffallend ist die geringe Empfindlichkeit gegenüber Sauerstoff. Diese erklärt sich aus der für einen Triplettemitter kurzen Lumineszenzabklingzeit in Toluol. Entsprechend der Löslichkeit von Sauerstoff in Toluol (1,97 $10^{-3}$ mol/L) und einer Abklingzeit von ca. 26 ns, ist die bimolekulare Stoßlöschung durch Sauerstoff nicht sehr effektiv. Aber auch die Abklingzeit im Festkörper von 230 - 250 ns ist für einen Triplettemitter recht kurz und lässt auf eine effektive Spin-Bahn-Kopplung schließen.

**gad) Messung von Absorptions- und Emissionsspektren an verschiedenen fac/mer-Isomerenverhältnissen des Ir-Komplexes (7) im PMMA-Filmen**

Um die Proben 1 bis 4 des Ir-Komplexes (7) weiter im verdünnten Festkörper zu charakterisieren, wurden entsprechende PMMA-Filme hergestellt. Für den PMMA-Film wurden 2 mg Farbstoff (Ir-Komplex (7), Beispiele 2c und 2d) pro 1 ml 10%ige (Massenprozent) PMMA-Lösung (PMMA in $CH_2Cl_2$) gelöst und mit einem 60 $\mu$m Rakel ein Film auf einen Objektträger ausgestrichen. Der Film trocknet sofort. Die Messungen in Toluol (spectroscopic grade) wurden bei einer Konzentration von 10 mg/l durchgeführt. Zur Entfernung des Sauerstoffs in der Lösung wurden vor der Messung 5 min lang Stickstoff ($O_2$-Gehalt <150 ppm) durch die Lösung geleitet und während der Messung Stickstoff über die Flüssigkeitsoberfläche geleitet. Alle Messungen erfolgten bei Raumtemperatur.

*Absorption:*

Das fac-Isomer (Beispiel 2d) absorbiert deutlich hypsochrom im Vergleich zum *mer*-Isomer (Beispiel 2d) und besitzt eine Schulter bei 330 nm. Die 80 / 20 Überlagerung der *fac* / *mer*-Spektren liefert identisch das Absorptionsspektrum der Ausgangsprobe. Etwas auffällig ist die verstärkte Absorption von Probe 2 um 280 nm. Es darf hier nicht vergessen werden, dass es sich bei den Absorptionsspektren um normierte Spektren handelt, die nur die Spektralform und nicht die absolute Absorptionsstärke wiedergeben.

*Emission*

Das Emissionsspektrum von Probe 3 ist wie schon zuvor in Toluol und im Pulver deutlich schmaler und rein blau. Probe 4 liegt im Maximum um 460 nm mit einer Schulter bei 400 - 410 nm. Auch hier liefert eine rechnerische Überlagerung (80 / 20) das Spektrum der Mischung.

Die Spektren in PMMA entsprechen denen in Toluol weitgehend. Jedoch spielt bei Lösungsspektren die Stoßlöschung der Phosphoreszenzemission eine Rolle, was keinen Einfluss auf die Emissionsspektren hat, aber die Photolumineszenzquantenausbeute vermindert. In der folgenden Tabelle 3 sind die Quantenausbeuten der 4 Proben in PMMA-Filmen und die Farbkoordinaten dargestellt.

*Tab. 3: Photolumineszenzquantenausbeuten sowie Farbkoordinaten in PMMA.*

| Probe # | QY[1] / % PMMA Exc[2] 325 nm | $X_{RGB}$ PMMA CIE 1931 | $Y_{RGB}$ PMMA CIE 1931 |
|---|---|---|---|
| Probe 1 | 19 | 0,160 | 0,078 |
| Probe 2 | 15 | 0,160 | 0,080 |
| Probe 3 (*fac*) | 17 | 0,160 | 0,047 |
| Probe 4 (*mer*) | 11 (exc 330 nm) | 0,164 | 0,165 |

[1] QY = Quantenausbeute
[2] Exc = Anregungswellenlänge

Die Quantenausbeute von Probe 4 liegt signifikant niedriger als die der 3 anderen Proben. Die Genauigkeit der Messung der Quantenausbeuten liegt bei Filmen und bei diesen Zahlenwerten in der Gegend von 2 %-Punkten, deutlich ungenauer als in Lösung, weil ein Film im Vergleich zur Lösung schlechter definiert, weil weniger homogen ist.

**gae) Zusammenfassung der optischen Charakterisierung von Komplex (7)**

Die Untersuchungen zeigen, dass das fac- und das mer-Isomer des Ir-Komplexes (7) sich deutlich in ihren

spektroskopischen Eigenschaften unterscheiden. *Fac*-(7) besitzt im Festkörper mit ca. 20 % eine fast doppelt so hohe Photolumineszenzquantenausbeute wie *mer*-(7). Während fac-(7) im rein Blauen emittiert, reicht die Emission von mer-(7) bis in türkisfarbene Bereiche. Aufgrund der Lage der Emissions- und Absorptionsbanden, sollte ein strahlungsloser Energietransfer von *fac*- zum *mer*-Isomer möglich sein (umgekehrt praktisch nicht), so dass bei anwendungsrelevanten Dotierungsgraden bzw. Emittermolekülabständen jede Verunreinigung von *mer-(7)* die Emission des fac-Isomers teilweise quencht, unabhängig von der Wirkung des *mer*-Isomers als Trap für einzelne Ladungen. Die daraus resultierende zusätzliche mer-Emission ist längerwellig und weniger effizient. Diese Interpretation wird gestützt durch die Messung der Konzentrationsabhängigkeit des Ir-Komplexes (7) in PMMA-Filmen. Für den Aufbau von Devices ist deshalb der Einsatz isomerenreiner Verbindungen des Ir-Komplexes (7) bevorzugt.

**h) Bestimmung der Quantenausbeute und Emissionseigenschaften des Komplexes (8)** in **Toluol und PMMA**

Für den PMMA-Film wurden 2 mg Farbstoff (Ir-Komplex (8)) pro 1 ml 10%ige (Massenprozent) PMMA-Lösung (PMMA in $CH_2Cl_2$) gelöst und mit einem 60 $\mu$m Rakel ein Film auf einen Objektträger ausgestrichen. Der Film trocknet sofort. Die Messungen in Toluol (spectroscopic grade) wurden bei einer Konzentration von 10 mg/l durchgeführt. Zur Entfernung des Sauerstoffs in der Lösung wurden vor der Messung 5 min lang Stickstoff ($O_2$-Gehalt <150 ppm) durch die Lösung geleitet und während der Messung Stickstoff über die Flüssigkeitsoberfläche geleitet. Alle Messungen erfolgten bei Raumtemperatur. Bei einer Anregungswellenlänge von 330 nm ergibt sich für den Emitter in PMMA eine Quantenausbeute von 10% und in Toluol eine Quantenausbeute von 3.6%. Das Emissionsmaximum liegt in Toluol und PMMA bei 512 nm. Die CIE-Koordinaten betragen in PMMA $X_{RGB}$ = 0.302, $Y_{RGB}$ = 0.591.

**3. Deviceaufbau**

Die Elektrolumineszenz des Komplexes (7) (siehe Beispiele 2c, 2d) sowie des Komplexes (8) (siehe Beispiel 2e) wurde jeweils in einem Device mit dem folgenden Schichtaufbau getestet:

**3a) Deviceaufbau eines Devices enthaltend Komplex (7) als Emittersubstanz**

Das als Anode eingesetzte ITO-Substrat wird zunächst durch Kochen in Isopropanol und Aceton gereinigt. Zwischendurch wird es mit Ultraschall behandelt. Abschließend werden die Substrate in einer Spülmaschine mit kommerziellen Reinigungsmitteln für die LCD Produktion (Deconex® 20NS und Neutralisationsmittel 25ORGANACID®) gesäubert. Zur Beseitigung eventuell verbliebener organischer Rückstände wird das Substrat für 25 Minuten einem kontinuierlichem Ozonfluss ausgesetzt. Diese Behandlung verbessert auch die Lochinjektion, da sich die Austrittsarbeit des ITOs erhöht.

Anschließend wird PEDT:PSS (Poly(3,4-ethylendioxythiophen)-Poly(styrolsulfonat)) (Baytron® P VP AI 4083) aus wässriger Lösung auf die Probe aufgeschleudert. Dabei ergibt sich eine Dicke von 46 nm. Danach folgt die Emitterschicht, die sich aus in Chlorbenzol gelöstem PMMA (Polymethacrylsäuremethylester) und der Emittersubstanz (Komplex (7), Beispiel 2c, Beispiel 2d) zusammensetzt. Es wird eine zweiprozentige Lösung aus PMMA in Chlorbenzol verwendet. Der Dotant (Emitter) wird in verschiedenen Konzentrationen dazu gegeben.

Die 28%ige Lösung ergibt nach dem Aufschleudern eine Dicke von ungefähr 61 nm und die 40%ige Lösung ergibt eine Dicke von 77 nm. Für diese Lösungen wurde ein Isomerengemisch (fac/mer) des Emitters eingesetzt, bei dem das faciale Isomer die Hauptkomponente stellt (Beispiel 2c). Des Weiteren wurde noch eine 30 %ige Lösung unter Verwendung des isomerenreinen fac-Emitters hergestellt (Beispiel 2d). Diese Lösung ergibt nach dem Aufschleudern eine Schichtdicke von 27 nm.

Zur besseren Balance der Ladungsträger werden dann 40 nm BCP (2,9-Dimethyl-4,7-diphenyl-1,10-phenanthrolin) aufgedampft. BCP ist für seine gute Leitfähigkeit für Elektronen bekannt, außerdem blockt es durch sein tief gelegenes HOMO Löcher, die das PMMA somit nur schwer verlassen können. Abschließend wird 1 nm Lithiumfluorid und 130 nm Aluminium als Kathode abgeschieden.

Zur Charakterisierung des Bauteils (OLED) werden dann Elektrolumineszenz-Spektren bei verschiedenen Strömen bzw. Spannungen aufgenommen. Weiterhin wird die Strom-Spannungskennlinie in Kombination mit der abgestrahlten Lichtleistung gemessen. Die Lichtleistung kann dann durch Kalibration mit einem Luminanzmeter in photometrische Größen umgerechnet werden.

Für die oben beschriebenen Bauteile (OLED) ergeben sich somit die folgenden elektrooptischen Daten:

| Device | PMMA Schichtdicke | Emissionsmaximum | Photometrischer Wirkungsgrad | Externe Quantenausbeute | Leuchtdichte |
|---|---|---|---|---|---|
| 28% Komplex 7 (fac/mer)1) | 61 nm | 453 nm | 0.8 cd/A | 1% | 30 $cd/m^2$ |
| 40% Komplex 7 (fac/mer)1) | 77 nm | 453 nm | 0.65 cd/A | 0.75% | 75 $cd/m^2$ |
| 30% Komplex 7 (reines fac)2) | 27 nm | 400 nm | 0.53 cd/A | 1.5% | 80 $cd/m^2$ |

1) Beispiel 2c
2) Beispiel 2d

**3b) Deviceaufbau eines Devices enthaltend Komplex (8) als Emittersubstanz**

Das als Anode eingesetzte ITO-Substrat wird zunächst für 10 Minuten mit Isopropanol bei 30 °C im Ultraschallbad und danach für 10 Minuten mit Chloroform ebenfalls im Ultraschallbad bei 30 °C gereinigt. Danach wird das Substrat zur Beseitigung eventuell verbliebener organischer Rückstände 20 Minuten im Sauerstoffplasma geätzt.

Danach wird als Lochleiter NPD bei $2 \times 10^{-5}$ mbar und einer Aufdampfrate von 0.2 Å/s auf das Substrat abgeschieden, so dass sich eine Schichtdicke von 40 nm ergibt. Anschließend wird Komplex (8) (Beispiel 2e) als 5 %iger Dotant zusammen mit dem Matrix-Material CBP aufgedampft. Die Dicke dieser Schicht beträgt ebenfalls 40 nm. Es folgen die BCP-Lochblockerschicht (6 nm) und eine Elektronenleiterschicht aus $Alq_3$ mit 20 nm Dicke. Schließlich wird eine 1 nm dicke LiF-Schicht aufgebracht und abschließend die Al-Elektrode aufgedampft.

Für das oben beschriebene Bauteil (OLED) erhält man einen photometrischen Wirkungsgrad von 6.4 cd/A bei einem Emissionsmaximum von 513 nm. Die maximale Leuchtdichte beträgt 1487 $cd/m^2$.

**Patentansprüche**

1. Organische Licht-emittierende Diode (OLED) umfassend mindestens einen neutralen Übergangsmetall-Komplex der allgemeinen Formel (I):

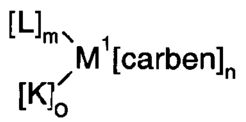

(I)

worin die Symbole die folgenden Bedeutungen aufweisen:

$M^1$ Metallatom Ir oder Pt in jeder für das entsprechende Metallatom möglichen Oxidationsstufe;
carben Carbenligand umfassend die folgende Formel (II)

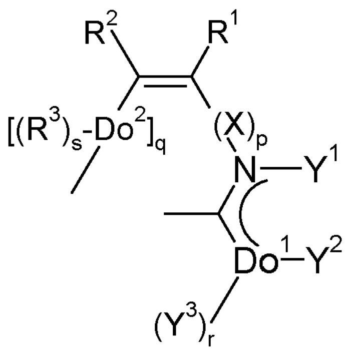

(II)

worin die Symbole die folgenden Bedeutungen aufweisen:

$Do^1$ Donoratom ausgewählt aus der Gruppe bestehend aus C, P, N, O und S, bevorzugt P, N, O und S, besonders bevorzugt N;
$Do^2$ Donoratom ausgewählt aus der Gruppe bestehend aus C, N, P, O und S;
r 2, wenn $Do^1$ C ist, 1, wenn $Do^1$ N oder P ist, und 0, wenn $Do^1$ O oder S ist;
s 2, wenn $Do^2$ C ist, 1, wenn $Do^2$ N oder P ist und 0, wenn $Do^2$ O oder S ist;
X Spacer ausgewählt aus der Gruppe bestehend aus Silylen, Alkylen, Arylen, Heteroarylen oder Alkenylen;
p 0 oder 1, bevorzugt 0;
q 0 oder 1, bevorzugt 0;
$Y^1$, $Y^2$ jeweils unabhängig voneinander Wasserstoff oder eine kohlenstoffhaltige Gruppe ausgewählt aus der Gruppe bestehend aus Alkyl-, Aryl-, Heteroaryl- und Alkenylgruppen;
oder
$Y^1$ und $Y^2$ bilden gemeinsam eine Brücke zwischen dem Donoratom $Do^1$ und dem Stickstoffatom N, die mindestens zwei Atome aufweist, wovon mindestens eines ein Kohlenstoffatom ist;
$Y^3$ ein Wasserstoff-, Alkyl-, Aryl-, Heteroaryl- oder Alkenylrest, oder

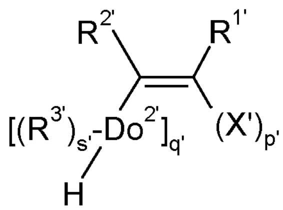

wobei $Do^{2'}$, q', s', $R^{3'}$, $R^{1'}$, $R^{2'}$, X' und p' unabhängig die gleichen Bedeutungen wie $Do^2$, q, s, $R^3$, $R^1$, $R^2$, X und p aufweisen;
$R^1$, $R^2$ unabhängig voneinander Wasserstoff, Alkyl-, Aryl-, Heteroaryl- oder Alkenylreste;
oder
$R^1$ und $R^2$ bilden gemeinsam eine Brücke mit insgesamt drei bis fünf Atomen, wovon ein oder zwei Atome Heteroatome sein können und die restlichen Atome Kohlenstoffatome sind, so dass die Gruppe

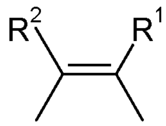

einen fünf-bis siebengliedrigen Ring bildet, der gegebenenfalls - neben der bereits vorhandenen Doppelbindung - eine - oder im Falle eines sechs- oder siebengliedrigen Rings - zwei weitere Doppelbindungen aufweisen kann und gegebenenfalls mit Alkyl- oder Arylgruppen substituiert sein kann und gegebenenfalls Heteroatome enthalten kann;
$R^3$ Wasserstoff, ein Alkyl-, Aryl-, Heteroaryl- oder Alkenylrest;

L mono-oder kann;dianionischer Ligand, der mono-oder bidentat sein
K neutraler Gruppe davon; Pyridinen; mit $M^1$ bilden;mono- oder bidentater Ligand ausgewählt aus der bestehend aus Phosphinen; Phosphonaten und Derivaten Arsenaten und Derivaten davon; Phosphiten; CO; Nitrilen und konjugierten Dienen, die einen $\pi$-Komplex
n Zahl der Carbenliganden, wobei n mindestens 1 ist und die Carbenliganden in dem Komplex der Formel I bei $n > 1$ gleich oder verschieden sein können;
m Zahl der Liganden L, wobei m 0 oder $\geq 1$ sein kann und die Liganden L bei $m > 1$ gleich oder verschieden sein können;
o Zahl der Liganden K, wobei o 0 oder $\geq 1$ sein kann und die Liganden K bei $o > 1$ gleich oder verschieden sein können;

wobei des L und der die Summe n + m + o von der Oxidationsstufe und Koordinationszahl eingesetzten Metallatoms und von der Zähnigkeit der Liganden carben, K sowie von der Ladung der Liganden carben und L abhängig ist, mit Bedingung, dass n mindestens 1 ist.

**2.** Organische Licht-emittierende Diode (OLED) gemäß Anspruch 1, wobei die Gruppierung

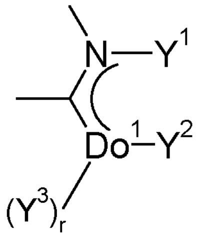

ausgewählt ist aus der Gruppe bestehend aus

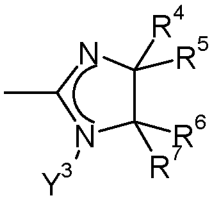

a

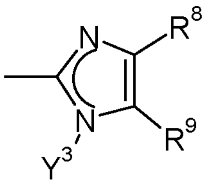

b

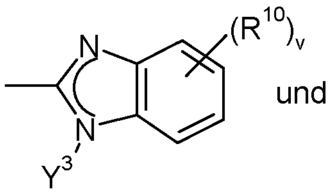

c

und

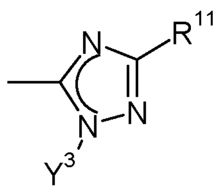

d

worin die Symbole die folgenden Bedeutungen aufweisen:

$R^4$, $R^5$, $R^6$, $R^7$, $R^8$, $R^9$ und $R^{11}$ Wasserstoff, Alkyl, Aryl, Heteroaryl, Alkenyl, oder ein Substituent mit Donor- oder Akzeptorwirkung;
$R^{10}$ Alkyl, Aryl, Heteroaryl, Alkenyl, bevorzugt Alkyl oder Aryl, oder jeweils 2 Reste $R^{10}$ bilden gemeinsam einen anellierten Ring, oder $R^{10}$ bedeutet einen Rest mit Donor- oder Akzeptorwirkung;
v 0 bis 4, wobei, wenn v 0 ist, die vier Kohlenstoffatome des Arylrests in Formel c, die gegebenenfalls mit $R^{10}$ substituiert sind, Wasserstoffatome tragen;
$Y^3$ ein Wasserstoff-, Alkyl-, Aryl-, Heteroaryl- oder Alkenylrest, oder

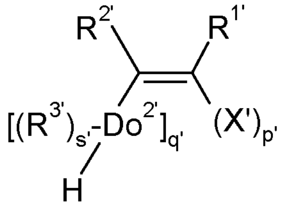

wobei $Do^{2'}$, q', s', $R^{3'}$, $R^{1'}$, $R^{2'}$, X' und p' unabhängig die gleichen Bedeutungen wie $Do^2$, q, s, $R^3$, $R^1$, $R^2$, X und p aufweisen.

**3.** Organische Licht-emittierende Diode (OLED) gemäß Anspruch 1 oder 2, wobei die Gruppierung

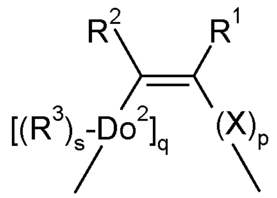

die folgende Struktur bedeutet:

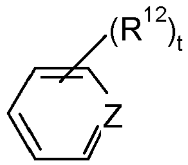

worin die Symbole die folgenden Bedeutungen aufweisen:

Z ist CH oder N, wobei Z in o-, m- oder p-Position zur Verknüpfungsstelle der Gruppierung mit der Gruppe

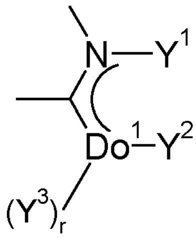

angeordnet sein kann;
$R^{12}$ ist ein Alkyl-, Aryl-, Heteroaryl- oder Alkenylrest, oder jeweils 2 Reste $R^{12}$ bilden gemeinsam einen anellierten Ring, der gegebenenfalls mindestens ein Heteroatom enthalten kann, oder $R^{12}$ bedeutet einen Rest mit Donor- oder Akzeptorwirkung; und
t ist 0 bis 3, wobei, wenn t > 1 ist, die Reste $R^{12}$ gleich oder verschieden sein können.

**4.** Organische Licht-emittierende Diode (OLED) gemäß einem der Ansprüche 1 bis 3, wobei die Struktur der Formel II ausgewählt ist aus der Gruppe bestehend aus:

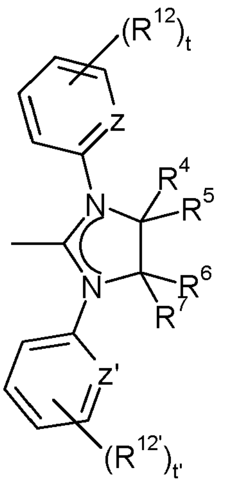
a

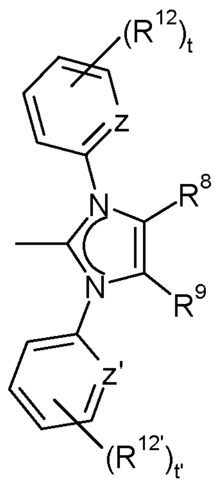
b

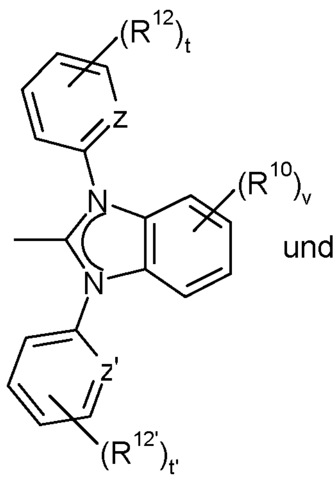
c

und

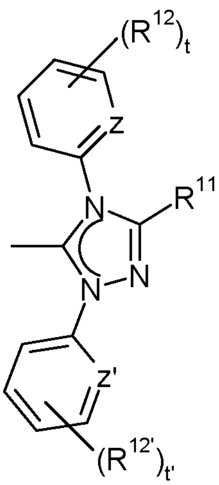
d

worin die Symbole die folgenden Bedeutungen aufweisen:

Z, Z' gleich oder verschieden, CH oder N;
$R^{12}$, $R^{12'}$ gleich oder verschieden, ein Alkyl-, Aryl-, Heteroaryl- oder Alkenylrest, oder jeweils 2 Reste $R^{12}$ bzw. $R^{12'}$ bilden gemeinsam einen anellierten Ring, der gegebenenfalls mindestens ein Heteroatom enthalten kann, oder $R^{12}$ bzw. $R^{12'}$ bedeutet einen Rest mit Donor- oder Akzeptorwirkung;
t und t' gleich oder verschieden 0 bis 3, wobei, wenn t bzw. t' > 1 ist, die Reste $R^{12}$ bzw. $R^{12'}$ gleich oder verschieden sein können;
$R^4$, $R^5$, $R^6$, $R^7$, $R^8$, $R^9$ und $R^{11}$ Wasserstoff, Alkyl, Aryl, Heteroaryl, Alkenyl oder ein Substituent mit Donor- oder Akzeptorwirkung;

$R^{10}$ Alkyl, Aryl, Heteroaryl oder Alkenyl, oder jeweils 2 Reste $R^{10}$ bilden gemeinsam einen anellierten Ring, der gegebenenfalls mindestens ein Heteroatom enthalten kann, oder $R^{10}$ bedeutet einen Rest mit Donor- oder Akzeptorwirkung;
v 0 bis 4, wobei, wenn v 0 ist, die vier Kohlenstoffatome des Arylrests in Formel c, die gegebenenfalls mit $R^{10}$ substituiert sind, Wasserstoffatome tragen.

**5.** Organische Licht-emittierende Diode (OLED) gemäß einem der Ansprüche 1 bis 4, wobei das Metallatom Pt(II) mit einer Koordinationszahl von 4 ist.

**6.** Organische Licht-emittierende Diode (OLED) nach Anspruch 5, wobei der Übergangsmetall-Komplex zwei Strukturen mit der Formel (II) umfasst.

**7.** Vorrichtung ausgewählt aus der Gruppe bestehend aus stationären Bildschirmen von Computern, Fernsehern, Bildschirme in Druckern, Küchengeräten sowie Reklametafeln, Beleuchtungen und Hinweistafeln; mobilen Bildschirmen in Handys, Laptops, Digitalkameras, Fahrzeugen sowie Zielanzeigen an Bussen und Bahnen, umfassend eine organische Licht-emittierende Diode (OLED) gemäß Anspruch 6.

## Claims

**1.** OLED comprising at least one neutral transition metal complex of general formula (I):

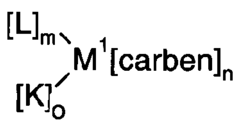

(I)

wherein the placeholders have the following meanings:

$M^1$ metal atom which is Ir or Pt, in any oxidation state possible for the respective metal atom;
carben carbene ligand comprising the following formula (II)

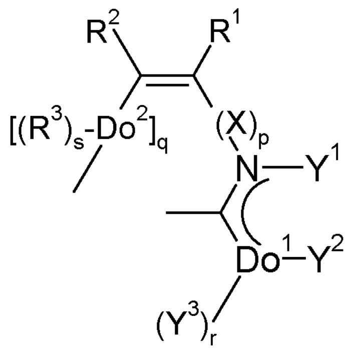

(II)

wherein the placeholders have the following meanings:

$Do^1$ donor atom selected from the group consisting of C, P, N, O and S, preferably P, N, O and S, especially preferred N;
$Do^2$ donor atom selected from the group consisting of C, N, P, O and S;
r 2 when $Do^1$ is C, 1 when $Do^1$ is N or P, and 0 when $Do^1$ is O or S;
s 2 when $Do^2$ is C, 1 when $Do^2$ is N or P, and 0 when $Do^2$ is O or S;
X spacer selected from the group consisting of silylene, alkylene, arylene, heteroarylene or alkenylene;
p 0 or 1, preferably 0;
q 0 or 1, preferably 0;
$Y^1$, $Y^2$ independently of each other hydrogen or a carbon-containing group selected from the group consisting of alkyl, aryl, heteroaryl and alkenyl groups;
or

$Y^1$ and $Y^2$ together form a bridge between the donor atom $Do^1$ and the nitrogen atom N which comprises at least two atoms, wherein at least one of these atoms is a carbon atom;
$Y^3$ a hydrogen, alkyl, aryl, heteroaryl or alkenyl group, or

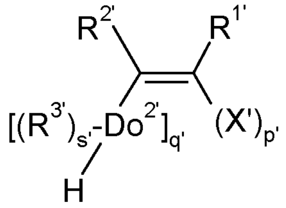

wherein $Do^{2'}$, q', s', $R^{3'}$, $R^{1'}$, $R^{2'}$, X' and p' independently of each other have the same meanings as $Do^2$, q, s, $R^3$, $R^1$, $R^2$, X and p;
$R^1$, $R^2$ independently of each other hydrogen, alkyl, aryl, heteroaryl or alkenyl groups;
or
$R^1$ and $R^2$ together form a bridge with a total of three to five atoms wherein one or two atoms can be heteroatoms and the remaining atoms are carbon atoms such that the group

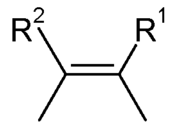

forms a five- to seven-membered ring which may contain - in addition to the double bond that is already present - one - or in case of a six- or seven-membered ring - two additional double bonds and which may be substituted with alkyl or aryl groups, and which may contain heteroatoms;
$R^3$ hydrogen, an alkyl, aryl, heteroaryl or alkenyl group;

L mono- or dianionic ligand which can be mono- or bidentate;
K neutral mono- or bidentate ligand selected from the group consisting of phosphines; phosphonates and derivatives thereof; arsenates and derivatives thereof; phosphites; CO; pyridines; nitriles and conjugated dienes which form a $\pi$-complex with $M^1$;
n number of the carbene ligands, wherein n is at least 1 and the carbene ligands in the complex of formula I can be the same or different when $n > 1$;
m number of the ligands L, wherein m can be 0 or $\geq 1$ and wherein the ligands L can be the same or different when $m > 1$;
o number of the ligands K, wherein o can be 0 or $\geq 1$ and wherein the ligands K can be the same or different when $o > 1$;

wherein the sum n + m + o depends on the oxidation state and coordination number of the metal atom that is used, and on the dentateness of the ligands carben, L and K, and on the charge of the ligands carben, L and K, provided that n is at least 1.

**2.** Organic Light-Emitting Diode (OLED) of claim 1, wherein the group

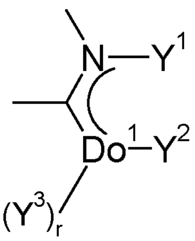

Is selected from the group consisting of

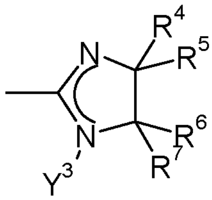
a

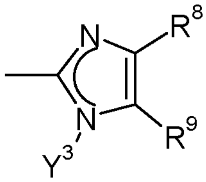
b

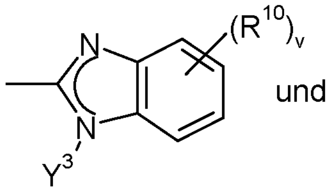
c

und

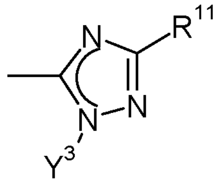
d

wherein the symbols have the following meanings:

$R^4$, $R^5$, $R^6$, $R^7$, $R^8$, $R^9$ and $R^{11}$ hydrogen, alkyl, aryl, heteroaryl, alkenyl, or a substituent having donor- or acceptor-properties;

$R^{10}$ alkyl, aryl, heteroaryl, alkenyl, preferably alkyl or aryl, or 2 $R^{10}$ together form an annellated ring, or $R^{10}$ means a substituent having donor- or acceptor-properties;

v 0 to 4, wherein, when v is 0, the four carbon atoms of the aryl group in Formula c, which may be substituted with $R^{10}$, are connected to hydrogen atoms;

$Y^3$ a hydrogen, alkyl aryl, heteroaryl or alkenyl group, or

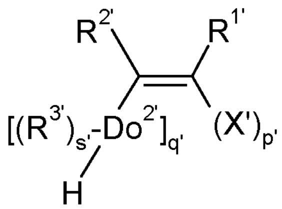

wherein $Do^{2'}$, q', s', $R^{3'}$, $R^{1'}$, $R^{2'}$, X' and p' independently of each other have the same meanings as $Do^2$, q, s, $R^3$, $R^1$, $R^2$, X and p.

**3.** Organic Light-Emitting Diode (OLED) of claim 1 or 2, wherein the group

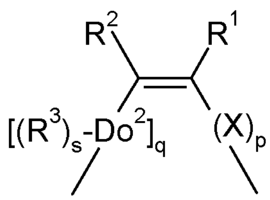

means the following structure:

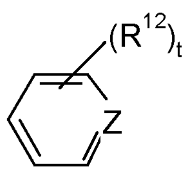

wherein the symbols have the following meanings:

Z is CH or N, wherein Z can be in o-, m- or p-position relative to the point of connection with the group

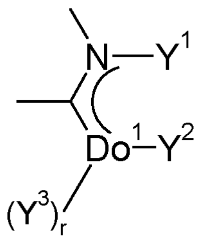

;

$R^{12}$ is an alky-, aryl, heteroaryl or alkenyl group, or 2 $R^{12}$ together form an annellated ring which may contain a heteroatom, or $R^{12}$ means a substituent having donor- or acceptor-properties; and
t is 0 to 3, wherein, when t is > 1, the $R^{12}$ are the same or different from each other.

4. Organic Light-Emitting Diode (OLED) of one of claims 1 to 3, wherein the structure of Formula II is selected from the group consisting of:

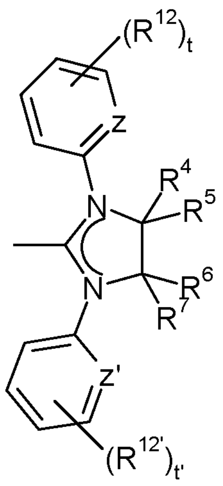

a

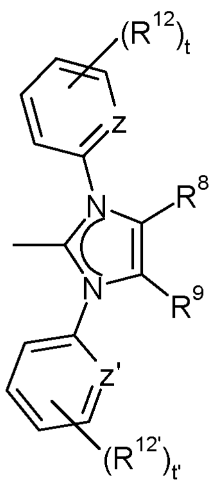

b

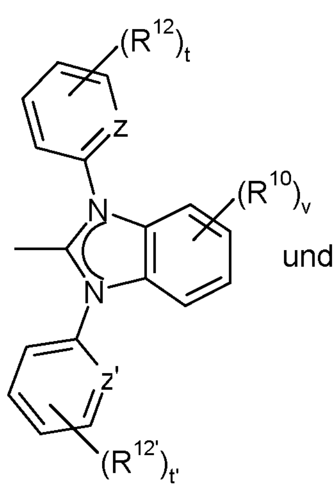

c

und

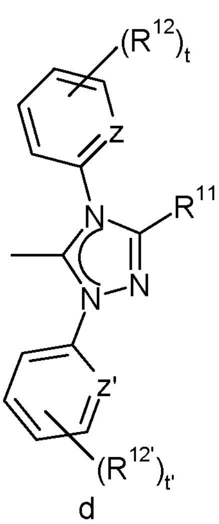

d

wherein the symbols have the following meanings:

Z, Z' same or different, CH or N;
$R^{12}$, $R^{12'}$ same or different, an alkyl, aryl, heteroaryl or alkenyl group, or 2 $R^{12}$ resp. $R^{12'}$ together form an annellated ring which may contain at least one heteroatom, or $R^{12}$ resp. $R^{12'}$ means a substituent having donor- or acceptor-properties;
t and t' same or different 0 to 3, wherein, when t resp. t' is > 1, the $R^{12}$ resp. $R^{12'}$ can be the same or different;
$R^4$, $R^5$, $R^6$, $R^7$, $R^8$, $R^9$ and $R^{11}$ hydrogen, alkyl, aryl, heteroaryl, alkenyl or a substituent with donor- or acceptor-properties;
$R^{10}$ alkyl, aryl, heteroaryl or alkenyl, or 2 $R^{10}$ together form an annellated ring which may contain at least one heteroatom, or $R^{10}$ means a substituent having donor- or acceptor-properties;
v 0 to 4, wherein, when v is 0, the four carbon atoms of the aryl group in Formula c, which may be substituted with $R^{10}$, are connected to hydrogen atoms.

5. Organic Light-Emitting Diode (OLED) of one of claims 1 to 4, wherein the metal atom is Pt(II) with a coordination number of 4.

6. Organic Light-Emitting Diode (OLED) of claim 5, wherein the transition metal complex comprises two structures of Formula (II).

7. Apparatus selected from the group consisting of stationary computer screens, televisions, printer screens, kitchen apparatuses and billboards, illuminations and signboards; mobile screens in mobile phones, laptops, digital cameras,

vehicles, and destination signs on buses and trains, comprising an Organic Light-Emitting Diode (OLED) of claim 6.

## Revendications

**1.** Diode électroluminescente organique (OLED) comprenant au moins un complexe d'un métal de transition neutre ayant la Formule générale (I) :

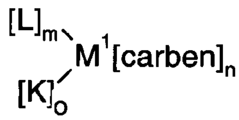

(I)

dans laquelle les symboles ont les significations suivantes :

$M^1$ représente un atome de métal Ir ou Pt dans chaque état d'oxydation possible de l'atome de métal correspondant,
carben est un ligand carbène ayant la Formule (II) suivante :

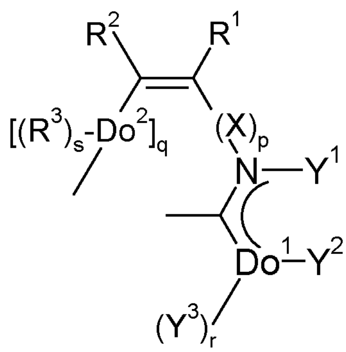

(II)

dans laquelle les symboles ont les significations suivantes :

$Do^1$ représente un atome donneur choisi parmi le groupe constitué de C, P, N, O et S, de manière préférée P, N, O et S, de manière particulièrement préférée N,
$Do^2$ représente un atome donneur choisi parmi le groupe constitué de C, N, P, O et S,
r est égal à 2 lorsque $Do^1$ représente C, à 1 lorsque $Do^1$ représente N ou P, et à 0 lorsque $Do^1$ représente O ou S,
s est égal à 2 lorsque $Do^2$ représente C, à 1 lorsque $Do^2$ représente N ou P, et à 0 lorsque $Do^2$ représente O ou S,
X représente un espaceur choisi parmi le groupe constitué de silyles, d'alkyles, d'aryles, d'hétéroaryles ou d'alcényles,
p est égal à 0 ou 1, de préférence 0,
q est égal à 0 ou 1, de préférence 0,
$Y^1$, $Y^2$ représentent respectivement, indépendamment l'un de l'autre, l'hydrogène, ou un groupe contenant du carbone choisi parmi le groupe constitué de groupes alkyle, aryle, hétéroaryle et alcényle,
ou
$Y^1$ et $Y^2$ forment ensemble un pont entre l'atome donneur $Do^1$ et l'atome d'azote N, qui comporte au moins deux atomes dont au moins un est un atome de carbone,
$Y^3$ représente un hydrogène ou un radical alkyle, aryle, hétéroaryle ou alcényle, ou

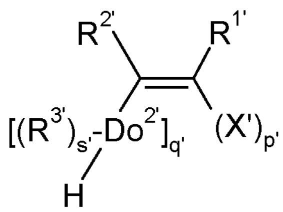

dans laquelle $Do^{2'}$, q', s', $R^{3'}$, $R^{1'}$, $R^{2'}$, X' et p' ont indépendamment les mêmes significations que $Do^2$, q, s, $R^3$, $R^1$, $R^2$, X et p,

$R^1$, $R^2$ représentent, indépendamment l'un de l'autre, l'hydrogène ou un radical alkyle, aryle, hétéroaryle ou alcényle,

ou

$R^1$ et $R^2$ forment ensemble un pont avec au total trois à cinq atomes, dont un ou deux atomes peuvent être des hétéroatomes et les atomes restants sont des atomes de carbone, de sorte que le groupe

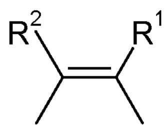

forme un noyau à cinq à sept chaînons qui peut comporter facultativement - en plus de la double liaison déjà existante - un - ou dans le cas d'un noyau à six ou sept chaînons - deux doubles liaisons supplémentaires, et qui peut facultativement être substitué par des groupes alkyle ou aryle et peut facultativement contenir des hétéroatomes,

$R^3$ représente l'hydrogène ou un radical alkyle, aryle, hétéroaryle ou alcényle,

L représente un ligand mono- ou dianionique qui peut être mono- ou bidenté,

K représente un ligand mono- ou bidenté neutre choisi parmi le groupe constitué de phosphines, de phosphonates et de dérivés de ceux-ci, d'arsenates et de dérivés de ceux-ci, de phosphites, de CO, de pyridines, de nitriles et de diènes conjugués, qui forment un complexe $\pi$ avec $M^1$,

n représente le nombre de ligands carbène, n étant au moins égal à 1 et les ligands carbène dans le complexe de Formule I peuvent être égaux ou différents lorsque n > 1,

m représente le nombre de ligands L, m pouvant être égal à 0 ou $\geq 1$ et les ligands L pouvant être identiques ou différents lorsque m > 1,

o représente le nombre de ligands K, o pouvant être égal à 0 ou $\geq 1$ et les ligands K pouvant être identiques ou différents lorsque o > 1,

dans laquelle la somme n + m + o dépend de l'état d'oxydation et de l'indice de coordination de l'atome de métal utilisé, et de la denticité des ligands carbène, L et K, ainsi que de la charge des ligands carbène et de L, à condition que n soit au moins égal à 1.,

**2.** Diode électroluminescente organique (OLED) selon la revendication 1, dans laquelle le groupement

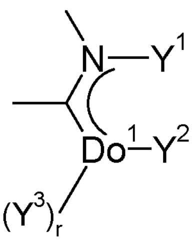

est choisi parmi le groupe constitué de :

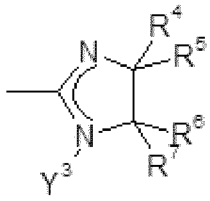
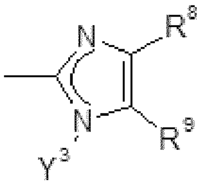
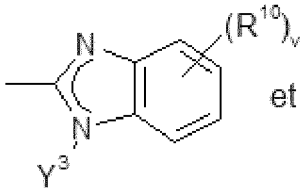
et
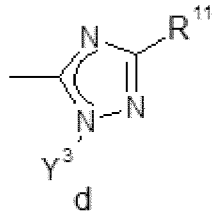

a b c d

dans lequel les symboles ont les significations suivantes :

$R^4$, $R^5$, $R^6$, $R^7$, $R^8$, $R^9$ et $R^{11}$ représentent l'hydrogène, un alkyle, un aryle, un hétéroaryle, un alcényle ou un substituant à effet donneur ou accepteur,
$R^{10}$ représente un alkyle, un aryle, un hétéroaryle, un alcényle, de préférence un alkyle ou un aryle, ou les 2 radicaux $R^{10}$ forment ensemble respectivement un cycle condensé, ou $R^{10}$ représente un radical à effet donneur ou accepteur,
v est compris entre 0 et 4, dans lequel, lorsque v est égal à 0, les quatre atomes de carbone du radical aryle de la formule c, qui sont facultativement substitués par $R^{10}$, portent des atomes d'hydrogène,
$Y^3$ représente un hydrogène ou un radical alkyle, aryle, hétéroaryle ou alcényle, ou

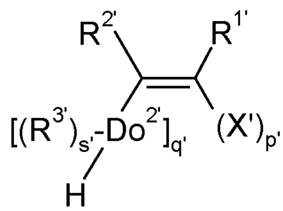

dans laquelle $Do^{2'}$, q', s', $R^{3'}$, $R^{1'}$, $R^{2'}$, X' et p' ont indépendamment les mêmes significations que $Do^2$, q, s, $R^3$, $R^1$, $R^2$, X et p.

**3.** Diode électroluminescente organique (OLED) selon la revendication 1 ou 2, dans laquelle le regroupement

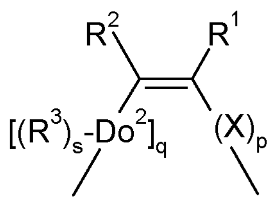

représente la structure suivante :

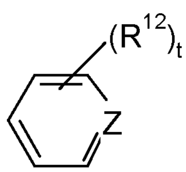

dans laquelle les symboles ont les significations suivantes :

Z représente CH ou N, Z pouvant être situé en position o, m ou p par rapport au point d'attache du groupement au groupe,

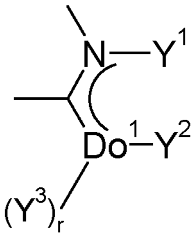

$R^{12}$ représente un radical alkyle, aryle, hétéroaryle ou alcényle, ou les 2 radicaux $R^{12}$ forment ensemble respectivement un cycle condensé qui peut facultativement contenir au moins un hétéroatome, ou $R^{12}$ représente un radical à effet donneur ou accepteur, et
t est compris entre 0 et 3, dans lequel, lorsque t > 1, les radicaux $R^{12}$ peuvent être identiques ou différents.

**4.** Diode électroluminescente organique (OLED) selon l'une des revendications 1 à 3, dans laquelle la structure de la Formule II est choisie parmi le groupe constitué de :

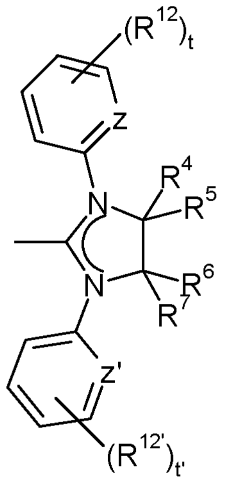

a

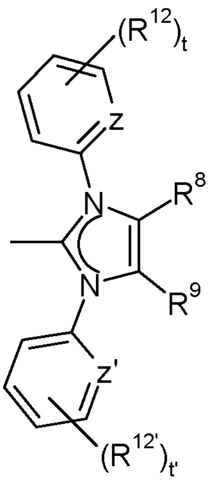

b

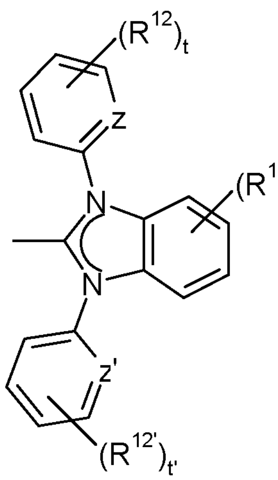

c

und

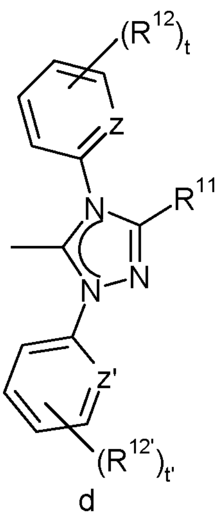

d

dans laquelle les symboles ont les significations suivantes :

Z, Z' peuvent être identiques ou différents et représentent CH ou N,
$R^{12}$, $R^{12'}$ peuvent être identiques ou différents et représentent un radical alkyle, aryle, hétéroaryle ou alcényle, ou les 2 radicaux $R^{12}$ ou $R^{12'}$ forment ensemble respectivement un cycle condensé pouvant facultativement contenir au moins un hétéroatome, ou $R^{12}$ ou $R^{12'}$ représente un radical à effet donneur ou accepteur,
t et t' peuvent être identiques ou différents et sont compris entre 0 et 3, dans lequel, lorsque t ou t' > 1, les radicaux $R^{12}$ ou $R^{12'}$ peuvent être identiques ou différents,
$R^4$, $R^5$, $R^6$, $R^7$, $R^8$, $R^9$ et $R^{11}$ représentent l'hydrogène, un alkyle, un aryle, un hétéroaryle, un alcényle ou un substituant à effet donneur ou accepteur,
$R^{10}$ représente un alkyle, un aryle, un hétéroaryle ou un alcényle, ou les 2 radicaux $R^{10}$ forment ensemble respectivement un cycle condensé pouvant facultativement contenir au moins un hétéroatome, ou $R^{10}$ représente un radical à effet donneur ou accepteur,
v est compris entre 0 et 4, dans lequel, lorsque v est égal à 0, les quatre atomes de carbone du radical aryle de la formule c, qui sont facultativement remplacés par $R^{10}$, portent des atomes d'hydrogène.

**5.** Diode électroluminescente organique (OLED) selon l'une des revendications 1 à 4, dans laquelle l'atome de métal Pt(II) a un indice de coordination de 4.

**6.** Diode électroluminescente organique (OLED) selon la revendication 5, dans laquelle le complexe d'un métal de transition comprend deux structures ayant la Formule (II).

7. Dispositif choisi parmi le groupe constitué d'écrans fixes d'ordinateurs, de téléviseurs, d'écrans d'imprimantes, d'appareils de cuisine ainsi que de panneaux publicitaires, d'éclairages et de panneaux d'information, d'écrans mobiles de téléphones portables, d'ordinateurs portables, d'appareils photo numériques, de véhicules ainsi que d'affichages de destination dans des bus et des trains, comprenant une diode électroluminescente organique (OLED) selon la revendication 6.

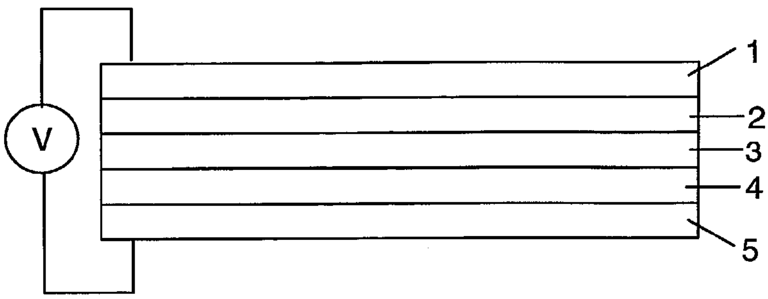


Fig. 1

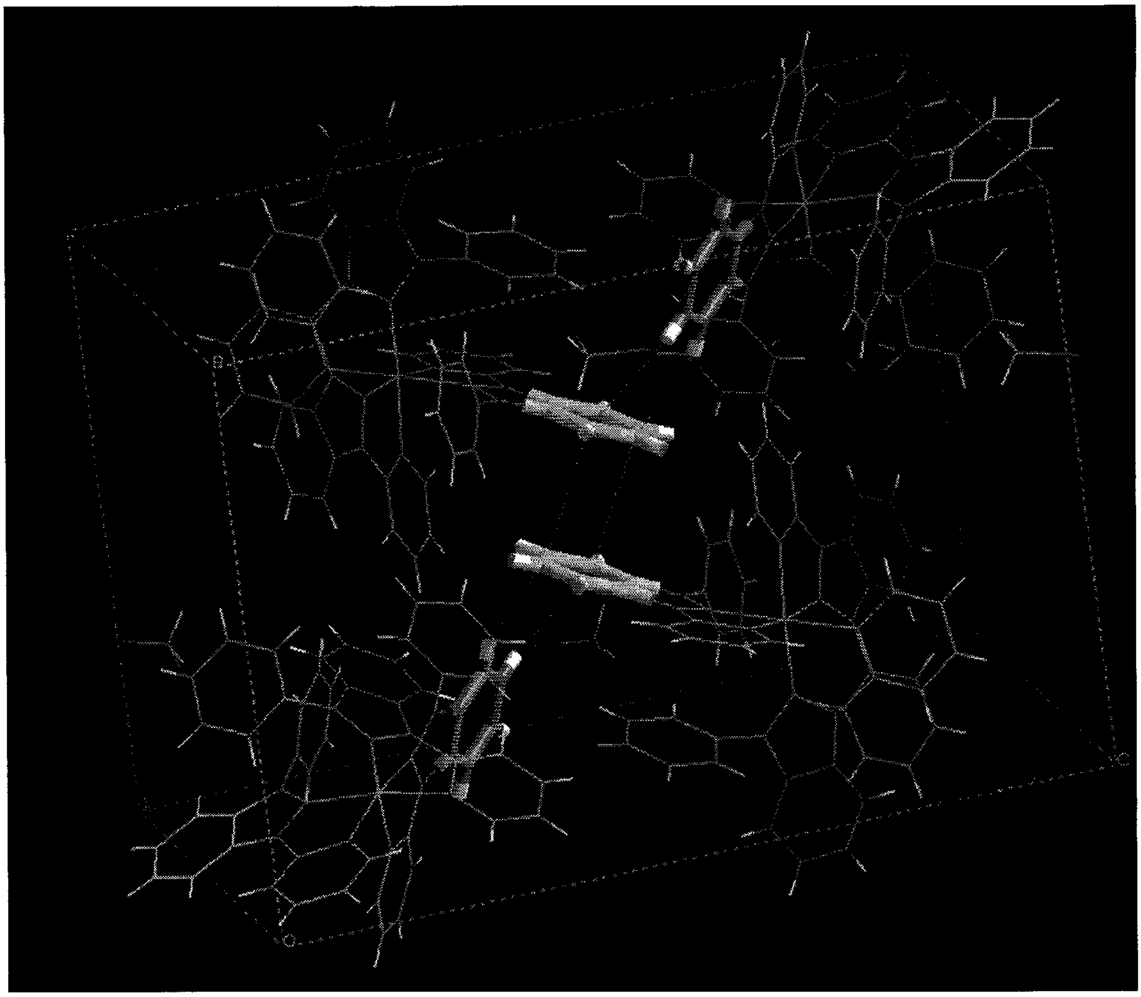

Fig. 2

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 0215645 A
- WO 0141512 A
- WO 0070655 A
- US 6160267 A
- US 6338977 B


### In der Beschreibung aufgeführte Nicht-Patentliteratur


- **J. HUHEEY ; E. KEITER ; R. KEITER.** Anorganische Chemie: Prinzipien von Struktur und Reaktivität. de Gruyter, 1995, 575, , 576
- **J. HUHEEY ; E. KEITER ; R, KEITER.** Anorganische Chemie: Prinzipien von Struktur und Reaktivität. de Gruyter, 1995, 557-559
- **GRÜNDEMANN et al.** *J. Am. Chem. Soc.,* 2002, vol. 124, 10473-10481
- **DANAPOULOS et al.** *J. Chem. Soc., Dalton Trans.,* 2002, 3090-3091
- **HITCHCOCK et al.** *J. Organomet. Chem.,* 1982, vol. 239, C26-C30
- **YAM et al.** *Chem. Commun.,* 1989, 2261-2262
- **YAM et al.** *J. Chem. Soc. Dalton Trans.,* 2001, 1911-1919
- **CHE et al.** *Organometallics,* 1998, vol. 17, 1622-1630
- **W. A. HERMANN et al.** *Advances in Organometallic Chemistry,* vol. 48, 1-69
- **W. A. HERMANN et al.** *Angew. Chem.,* 1997, vol. 109, 2256-2282
- **G. BERTRAND et al.** *Chem. Rev.,* 2000, vol. 100, 39-91
- *Nature,* 11. Juni 1992, vol. 357, 477-479
- **KIRK-OTHMER.** Encyclopedia of Chemical Technologie. 1996, vol. 18, 837-860
- **W. GAO ; A. KAHN.** *J. Appl. Phys.,* 01. Juli 2003, vol. 94 (1
- **A. G. WERNER ; F. LI ; K. HARADA ; M. PFEIFFER ; T. FRITZ ; K. LEO.** *Appl. Phys. Lett.,* 23. Juni 2003, vol. 82 (25
- **PFEIFFER et al.** *Organic Electronics,* 2003, vol. 4, 89-103
- *Organic Letters,* 1999, vol. 1, 953-956
- *Angewandte Chemie,* 2000, vol. 112, 1672-1674
- *Chem. Ber.,* 1971, vol. 104, 92-109
- *Journal of Organometallic Chemistry,* 2002, vol. 606, 49-54
- *Synthetic Communications,* 2000, vol. 30, 3651-3668
- **P. B. HITCHCOCK ; M. F. LAPPERT ; P. TERREROS.** *J. Organomet. Chem.,* 1982, vol. 239, C26-C30